# EUROPEAN PATENT SPECIFICATION

(11) **EP 4 135 046 B1**
(45) Date of publication and mention of the grant of the patent: **01.10.2025**
(21) Application number: 22190007.9
(22) Date of filing: 11.08.2022
(51) Int. Cl.: H10K 50/19, H10K 59/32, H10K 59/122, H10K 59/35

(54) **DISPLAY APPARATUS**
ANZEIGEVORRICHTUNG
APPAREIL D'AFFICHAGE

(30) Priority: 13.08.2021 KR 20210107611
(43) Date of publication of application: 15.02.2023
(73) Proprietor: Samsung Display Co., Ltd., Yongin-si, Gyeonggi-do 17113 (KR)
(72) Inventor: PARK, Jungsun, 17113 Yongin-si (KR); GWARK, Hyejin, 17113 Yongin-si (KR); KIM, Arong, 17113 Yongin-si (KR); KIM, Jaeik, 17113 Yongin-si (KR); PARK, Heemin, 17113 Yongin-si (KR); SONG, Seungyong, 17113 Yongin-si (KR); LEE, Duckjung, 17113 Yongin-si (KR); LEE, Yeonhwa, 17113 Yongin-si (KR); LEE, Joongu, 17113 Yongin-si (KR); HWANG, Kyuhwan, 17113 Yongin-si (KR)
(74) Representative: Marks & Clerk LLP

(56) References cited:
- US-A1- 2015 069 361
- US-A1- 2021 175 296

## Description

### BACKGROUND

### FIELD

Embodiments of the invention relate generally to a display apparatus.

### DISCUSSION OF THE BACKGROUND

A display apparatus may include a display element. For example, the display element may be an organic light-emitting diode. Organic light-emitting diodes have the advantages of a wide viewing angle, high contrast, a fast response time, and excellent luminance, driving voltage, and response time characteristics, and may display multiple colors.

An organic light-emitting diode may include sequentially stacked elements of a pixel electrode, a hole transport layer, an emission layer, an electron transport layer, and a common electrode. Holes injected into the pixel electrode may move to the emission layer via the hole transport layer, and electrons injected from the common electrode may move to the emission layer via the electron transport layer. Carriers such as the holes and the electrons may recombine in the emission layer to generate excitons. The excitons may change from an excited state to a ground state to emit light.

The above information disclosed in this Background section is only for understanding of the background of the inventive concepts, and, therefore, it may contain information that does not constitute prior art.
US 2021/175296 A1 relates to a display panel and a way for manufacturing a display panel. US 2015/069361 A1 and US 2021/126215 A1 relate to an organic electroluminescent display device and a method of manufacturing the same.

### SUMMARY

Devices constructed according to illustrative implementations of the invention may provide a display element according to the claims having a structure in which a plurality of emission layers are stacked, and further includes a charge generation layer located between the plurality of emission layers. The charge generation layer that is commonly provided in a plurality of display elements is continuously provided in the plurality of display elements.

One or more embodiments include a display apparatus including a plurality of display elements provided with a charge generation layer which may prevent or reduce color purity degradation.

Additional features of the inventive concepts will be set forth in the description which follows, and in part will be apparent from the description, or may be learned by practice of the inventive concepts.

According to one or more embodiments, a display apparatus is according to the claims and includes a substrate including a display area, a first electrode located in the display area, a second electrode located in the display area to be adjacent to the first electrode, a first emission layer located on the first electrode, a second emission layer located on the second electrode, a first negative charge generation layer continuously located to cover the first emission layer and the second emission layer and including a host including an organic material and a dopant including a metal material, a first positive charge generation layer located on the first negative charge generation layer, a first upper emission layer located on the first positive charge generation layer and overlapping the first emission layer, a second upper emission layer located on the first positive charge generation layer and overlapping the second emission layer, and a common electrode located on the first upper emission layer and the second upper emission layer, wherein the dopant is provided at a first ratio in an overlapping area of the first negative charge generation layer located between a center of the first emission layer and a center of the second emission layer in a plan view, and the dopant is provided at a second ratio in an outside area of the first negative charge generation layer located outside the overlapping area, wherein the first ratio is less than the second ratio.

The host may be provided in the overlapping area and the outside area, and the dopant may be provided in the outside area.

The display apparatus may further include a first adhesive pattern located in the overlapping area, wherein the first negative charge generation layer is continuously located to further cover the first adhesive pattern.

The first negative charge generation layer and the first adhesive pattern may directly contact each other.

The display apparatus may further include a third electrode located in the display area to be adjacent to the second electrode, a third emission layer located on the third electrode, a second adhesive pattern located between the center of the second emission layer and a center of the third emission layer in a plan view, and a third upper emission layer overlapping the third emission layer, wherein the first negative charge generation layer is continuously located to further cover the second adhesive pattern, and the third emission layer, and the common electrode is further located on the third upper emission layer.

The first emission layer may emit red light, the second emission layer may emit green light, and the third emission layer may emit blue light.

The display apparatus may further include a first additional adhesive pattern located between a center of the first upper emission layer and a center of the second upper emission layer in a plan view, a second negative charge generation layer continuously located to cover the first upper emission layer, the second upper emission layer, and the first additional adhesive pattern, a second positive charge generation layer located on the second negative charge generation layer, a first additional emission layer located on the second positive charge generation layer and overlapping the first upper emission layer, and a second additional emission layer located on the second positive charge generation layer and overlapping the second upper emission layer, wherein the common electrode is further located on the first additional emission layer and the second additional emission layer.

The display apparatus may further include a pixel-defining layer including a first opening portion overlapping the first electrode and a second opening portion overlapping the second electrode, wherein the first adhesive pattern is located between the first opening portion and the second opening portion in a plan view.

The first adhesive pattern may at least partially surround a perimeter of at least one of the first opening portion and the second opening portion.

The first adhesive pattern may include a fluoro group.

The display apparatus further includes a first adhesive pattern located between a center of the first emission layer and a center of the second emission layer in a plan view, wherein the first negative charge generation layer is continuously located to cover the first adhesive pattern, and wherein the dopant overlaps the first adhesive pattern.

The host may be provided in the overlapping area and the outside area, and the dopant may be provided in the outside area.

The first negative charge generation layer and the first adhesive pattern may directly contact each other.

The display apparatus may further include a third electrode located in the display area to be adjacent to the second electrode, a third emission layer located on the third electrode, a second adhesive pattern located between the center of the second emission layer and a center of the third emission layer in a plan view, and a third upper emission layer overlapping the third emission layer, wherein the first negative charge generation layer is continuously located to further cover the second adhesive pattern and the third emission layer, and the common electrode is further located on the third upper emission layer.

The first emission layer may emit red light, the second emission layer may emit green light, and the third emission layer may emit blue light.

The display apparatus may further include a first additional adhesive pattern located between a center of the first upper emission layer and a center of the second upper emission layer in a plan view, a second negative charge generation layer continuously located to cover the first upper emission layer, the second upper emission layer, and the first additional adhesive pattern, a second positive charge generation layer located on the second negative charge generation layer, a first additional emission layer located on the second positive charge generation layer and overlapping the first upper emission layer, and a second additional emission layer located on the second positive charge generation layer and overlapping the second upper emission layer, wherein the common electrode is further located on the first additional emission layer and the second additional emission layer.

The display apparatus may further include a pixel-defining layer including a first opening portion overlapping the first electrode and a second opening portion overlapping the second electrode, wherein the first adhesive pattern is located between the first opening portion and the second opening portion in a plan view.

The first adhesive pattern may at least partially surround a perimeter of at least one of the first opening portion and the second opening portion.

The first adhesive pattern may include a fluoro group.

At least some of the above and other features of the invention are set out in the claims.

It is to be understood that both the foregoing general description and the following detailed description are illustrative and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate illustrative embodiments of the invention, and together with the description serve to explain the inventive concepts.
FIG. 1 is a schematic perspective view of a display apparatus, according to an embodiment.
FIGS. 2A and 2B are cross-sectional views taken along line A-A' of the display apparatus of FIG. 1.
FIG. 3 is a plan view illustrating a display panel, according to an embodiment.
FIG. 4 is an equivalent circuit diagram illustrating one pixel of the display panel, according to an embodiment.
FIG. 5 is a cross-sectional view taken along line B-B' of the display panel of FIG. 3.
FIG. 6 is a cross-sectional view taken along line B-B' of the display panel of FIG. 3.
FIG. 7 is an enlarged view illustrating a portion C of the display panel of FIG. 3, according to an embodiment.
FIG. 8 is an enlarged view illustrating a portion D of the display panel of FIG. 7.
FIGS. 9A, 9B, 9C, and 9D are enlarged views illustrating the portion C of the display panel of FIG. 3, according to various embodiments.
FIG. 10 is a cross-sectional view taken along line E-E' of the display panel of FIG. 7.
FIG. 11 is a cross-sectional view illustrating that a first organic light-emitting diode emits light in the display panel of FIG. 10.
FIG. 12 is a graph illustrating a light transmittance of a display panel according to an embodiment and a light transmittance of a display panel according to a comparative example.
FIGS. 13A, 13B, and 13C are cross-sectional views illustrating a method of manufacturing a display apparatus, according to an embodiment.

### DETAILED DESCRIPTION

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the x-axis, the y-axis, and the z-axis are not limited to three axes of a rectangular coordinate system, such as the typical x, y, and z - axes, and may be interpreted in a broader sense. For example, the x-axis, the y-axis, and the z-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

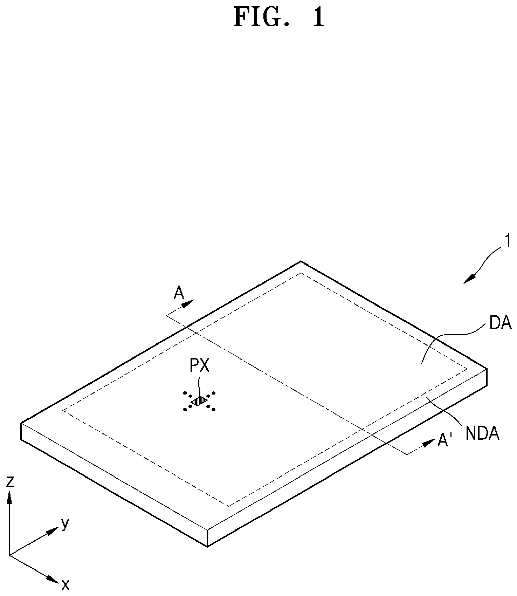

FIG. 1 is a perspective view illustrating a display apparatus 1, according to an embodiment.

Referring to FIG. 1, the display apparatus 1 may display an image. In an embodiment, the display apparatus 1 may be an organic light-emitting display apparatus. In another embodiment, the display apparatus 1 may be an inorganic light-emitting display apparatus or a quantum-dot light-emitting display apparatus. For example, an emission layer of a display element included in the display apparatus may include an organic material, may include an inorganic material, may include quantum dots, may include an organic material and quantum dots, may include an inorganic material and quantum dots, or may include an organic material, an inorganic material, and quantum dots. For convenience of explanation, the following will be described assuming that the display apparatus 1 is an organic light-emitting display apparatus.

The display apparatus 1 may include a display area DA and a non-display area NDA. A pixel PX may be located in the display area DA. The non-display area NDA may at least partially surround the display area DA. The pixel PX may not be located in the non-display area NDA.

Although the display area DA of the display apparatus 1 has a quadrangular shape (i.e., a rectangle) in FIG. 1, in another embodiment, the display area DA may have a circular shape, an elliptical shape, or a polygonal shape such as a triangular shape or a pentagonal shape. Also, although the display apparatus 1 of FIG. 1 is a flat panel display apparatus, the display apparatus 1 may be implemented as any of various apparatuses such as a flexible, foldable, or rollable display apparatus.

A plurality of pixels PX may be located in the display area DA. The plurality of pixels PX may emit light, and the display apparatus 1 may display an image in the display area DA. The term "pixel PX" used herein may refer to a sub-pixel that emits light. For example, each pixel PX may be one of a red sub-pixel, a green sub-pixel, and a blue sub-pixel. In another example, each pixel PX may be one of a red sub-pixel, a green sub-pixel, a blue sub-pixel, and a white sub-pixel.

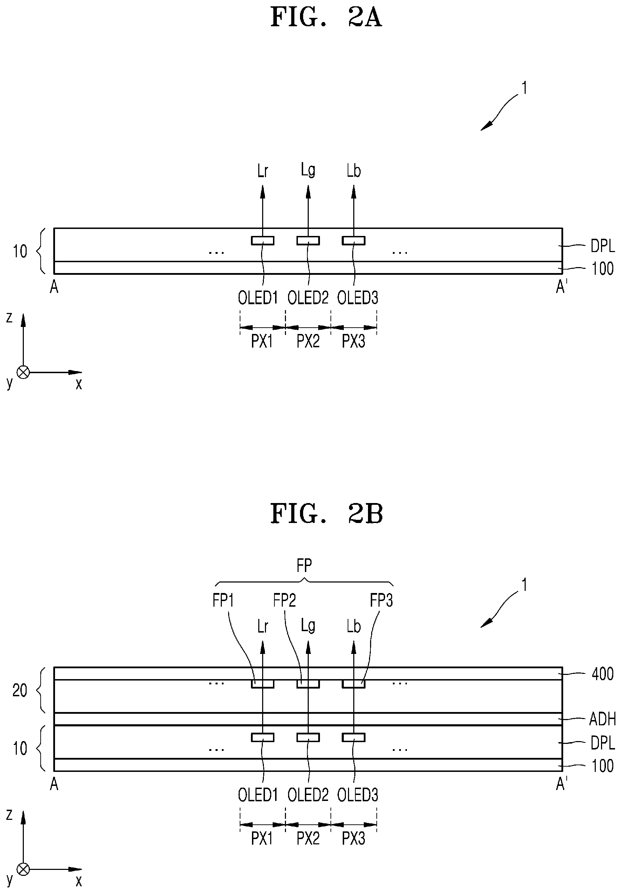

FIGS. 2A and 2B are cross-sectional views taken along line A-A' of the display apparatus 1 of FIG. 1.

Referring to FIGS. 2A and 2B, the display apparatus 1 may include a first pixel PX1, a second pixel PX2, and a third pixel PX3. The first pixel PX1, the second pixel PX2, and the third pixel PX3 may be pixels that emit light of different colors. For example, the first pixel PX1 may emit red light Lr, the second pixel PX2 may emit green light Lg, and the third pixel PX3 may emit blue light Lb.

Referring to FIG. 2A, the display apparatus 1 may include a display panel 10. The display panel 10 may include a substrate 100 and a display layer DPL. The display layer DPL may be located on the substrate 100. In an embodiment, the display layer DPL may include a pixel circuit and a display element driven by the pixel circuit. The display element may be, for example, an organic light-emitting diode. Each of the first pixel PX1, the second pixel PX2, and the third pixel PX3 may include an organic light-emitting diode. In an embodiment, the first pixel PX1 may include a first organic light-emitting diode OLED1. The second pixel PX2 may include a second organic light-emitting diode OLED2. The third pixel PX3 may include a third organic light-emitting diode OLED3.

In an embodiment, the first organic light-emitting diode OLED1 may emit the red light Lr. The second organic light-emitting diode OLED2 may emit the green light Lg. The third organic light-emitting diode OLED3 may emit the blue light Lb. In some embodiments, the display layer DPL may further include a fourth organic light-emitting diode that emits white light.

Referring to FIG. 2B, the display apparatus 1 may include the display panel 10 and a color conversion panel 20. The display panel 10 may include the substrate 100 and the display layer DPL. In an embodiment, the first pixel PX1 may include the first organic light-emitting diode OLED1. The second pixel PX2 may include the second organic light-emitting diode OLED2. The third pixel PX3 may include the third organic light-emitting diode OLED3.

In an embodiment, the first organic light-emitting diode OLED1, the second organic light-emitting diode OLED2, and the third organic light-emitting diode OLED3 may emit light of different colors. In another embodiment, the first organic light-emitting diode OLED1, the second organic light-emitting diode OLED2, and the third organic light-emitting diode OLED3 may emit light of the same color. For example, each of the first organic light-emitting diode OLED1, the second organic light-emitting diode OLED2, and the third organic light-emitting diode OLED3 may emit blue light. Each of the first organic light-emitting diode OLED1, the second organic light-emitting diode OLED2, and the third organic light-emitting diode OLED3 may alternately emit white light.

The color conversion panel 20 may be located on the display panel 10. The color conversion panel 20 may include an upper substrate 400 and a filter unit FP. In an embodiment, the filter unit FP may include a first filter unit FP1, a second filter unit FP2, and a third filter unit FP3. Light emitted by the first organic light-emitting diode OLED1 may be emitted as the red light Lr through the first filter unit FP1. Light emitted by the second organic light-emitting diode OLED2 may be emitted as the green light Lg through the second filter unit FP2. Light emitted by the third organic light-emitting diode OLED3 may be emitted as the blue light Lb through the third filter unit FP3.

In an embodiment, the filter unit FP may include a functional layer and a color filter layer. In an embodiment, the functional layer may include a first quantum dot layer, a second quantum dot layer, and a transmissive layer. In an embodiment, the color filter layer may include a first color filter, a second color filter, and a third color filter. The first filter unit FP1 may include the first quantum dot layer and the first color filter. The second filter unit FP2 may include the second quantum dot layer and the second color filter. The third filter unit FP3 may include the transmissive layer and the third color filter.

The filter unit FP may be located directly on the upper substrate 400. In this case, when the filter unit FP is located 'directly on the upper substrate', it may mean that the color conversion panel 20 is manufactured by directly forming the first color filter, the second color filter, and the third color filter on the upper substrate 400. Next, the color conversion panel 20 may be adhered to the display panel 10 so that the first filter unit FP1, the second filter unit FP2, and the third filter unit FP3 respectively face the first organic light-emitting diode OLED1, the second organic light-emitting diode OLED2, and the third organic light-emitting diode OLED3.

In FIG. 2B, the display panel 10 and the color conversion panel 20 are adhered to each other through an adhesive layer ADH. The adhesive layer ADH may be, for example, an optically clear adhesive (OCA). In another embodiment, the display panel 10 may be adhered to the color conversion panel 20 through a filler. In another embodiment, the adhesive layer ADH and the filler may be omitted.

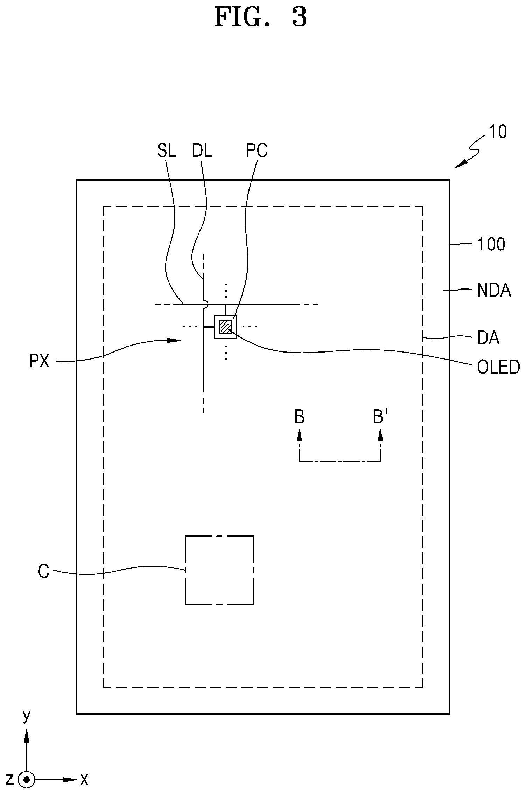

FIG. 3 is a plan view illustrating the display panel 10, according to an embodiment.

Referring to FIG. 3, the display panel 10 may include the substrate 100, the pixel PX, a scan line SL, and a data line DL. The display panel 10 may include the display area DA and the non-display area NDA. In an embodiment, the display area DA and the non-display area NDA may be defined in the substrate 100. In other words, the substrate 100 may include the display area DA and the non-display area NDA. The pixel PX may be located in the display area DA. A driving circuit and/or a power supply wiring of the display panel 10 may be located in the non-display area NDA.

The pixel PX may be located in the display area DA. The pixel PX may emit light. In an embodiment, a plurality of pixels PX may be provided, and the display panel 10 may display an image by using light emitted by the plurality of pixels PX. The pixel PX may include a pixel circuit PC and an organic light-emitting diode OLED that is a display element driven by the pixel circuit PC.

The pixel circuit PC may be electrically connected to the scan line SL for transmitting a scan signal and the data line DL for transmitting a data signal. The pixel PX may receive the scan signal and the data signal and may emit light.

The scan line SL may be configured to transmit a scan signal. In an embodiment, the scan line SL may extend in a first direction (e.g., an x direction or a -x direction). The scan line SL may be electrically connected to the pixel circuit PC. In an embodiment, the scan line SL may receive a scan signal from the driving circuit (not shown).

The data line DL may be configured to transmit a data signal. In an embodiment, the data line DL may extend in a second direction (e.g., a y direction or a -y direction). The data line DL may be electrically connected to the pixel circuit PC.

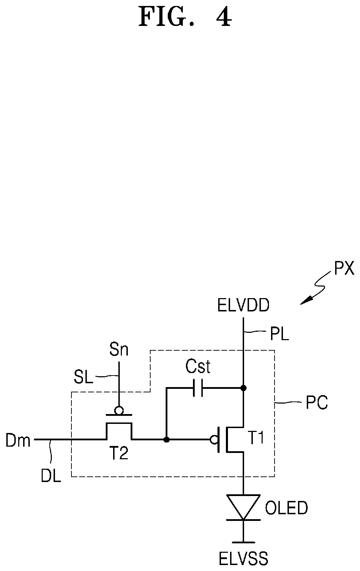

FIG. 4 is an equivalent circuit diagram illustrating one pixel PX of the display panel 10, according to an embodiment.

Referring to FIG. 4, the pixel PX may include the pixel circuit PC, and the organic light-emitting diode OLED that is a display element electrically connected to the pixel circuit PC. The pixel circuit PC may include a driving thin-film transistor T1, a switching thin-film transistor T2, and a storage capacitor Cst.

The switching thin-film transistor T2 may be connected to the scan line SL and the data line DL, and may transmit, to the driving thin-film transistor T1, a data voltage or a data signal Dm input from the data line DL according to a scan voltage or a scan signal Sn input from the scan line SL.

The storage capacitor Cst may be connected to the switching thin-film transistor T2 and a driving voltage line PL, and may store a voltage corresponding to a difference between a voltage received from the switching thin-film transistor T2 and a first power supply voltage ELVDD supplied to the driving voltage line PL.

The driving thin-film transistor T1 may be connected to the driving voltage line PL and the storage capacitor Cst, and may control driving current flowing through the organic light-emitting diode OLED from the driving voltage line PL in response to a value of the voltage stored in the storage capacitor Cst. The organic light-emitting diode OLED may emit light having a certain luminance according to the driving current. A common electrode (e.g., a cathode) of the organic light-emitting diode OLED may receive a second power supply voltage ELVSS.

Although the pixel circuit PC includes two thin-film transistors and one storage capacitor in FIG. 4, in another embodiment, the pixel circuit PC may include three or more thin-film transistors.

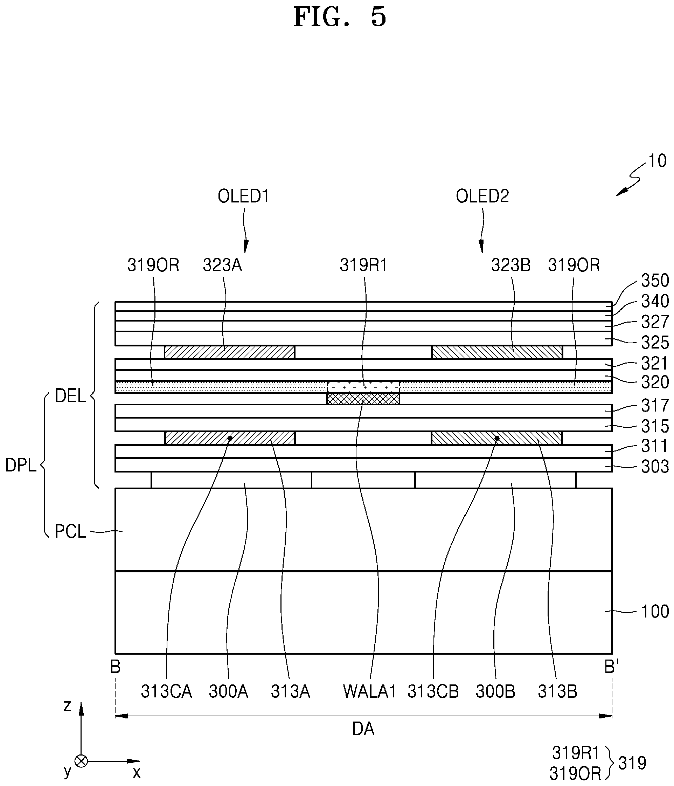

FIG. 5 is a cross-sectional view taken along line B-B' of the display panel 10 of FIG. 3.

Referring to FIG. 5, the display panel 10 may include the substrate 100 and the display layer DPL. The substrate 100 may include the display area DA. In an embodiment, the substrate 100 may include glass. In another embodiment, the substrate 100 may include a polymer resin such as polyethersulfone, polyarylate, polyetherimide, polyethylene naphthalate, polyethylene terephthalate, polyphenylene sulfide, polyimide, polycarbonate, cellulose triacetate, or cellulose acetate propionate. In an embodiment, the substrate 100 may have a multi-layer structure including a base layer including the polymer resin and a barrier layer (not shown).

The display layer DPL may be located on the substrate 100. The display layer DPL may include a pixel circuit layer PCL and a display element layer DEL. The pixel circuit layer PCL may be located on the substrate 100, and may include a pixel circuit for driving a display element and an insulating layer.

The display element layer DEL may be located on the pixel circuit layer PCL. The display element layer DEL may include a display element. In an embodiment, the display element layer DEL may include a first electrode 300A, a second electrode 300B, a first hole injection layer 303, a first stack, a first (low) adhesive pattern WALA1, a first negative charge generation layer 319, a first positive charge generation layer 320, a second stack, a common electrode 340, and a capping layer 350. In an embodiment, the first stack may include a first hole transport layer 311, a first emission layer 313A, a second emission layer 313B, a first buffer layer 315, and a first electron transport layer 317. The second stack may include a second hole transport layer 321, a first upper emission layer 323A, a second upper emission layer 323B, a second buffer layer 325, and a second electron transport layer 327.

The first electrode 300A, the first emission layer 313A, the first upper emission layer 323A, and the common electrode 340 may constitute the first organic light-emitting diode OLED1 that is a first display element. The second electrode 300B, the second emission layer 313B, the second upper emission layer 323B, and the common electrode 340 may constitute the second organic light-emitting diode OLED2 that is a second display element.

The first electrode 300A and the second electrode 300B are located in the display area DA. In an embodiment, the first electrode 300A and the second electrode 300B may be located close to each other. In other words, the first electrode 300A and the second electrode 300B are adjacent to each other. The first electrode 300A and the second electrode 300B may respectively supply holes to the first emission layer 313A and the second emission layer 313B. In an embodiment, each of the first electrode 300A and the second electrode 300B may be a pixel electrode.

The first electrode 300A may include a conductive oxide such as indium tin oxide (ITO), indium zinc oxide (IZO), zinc oxide (ZnO), indium oxide (In₂O₃), indium gallium oxide (IGO), or aluminium zinc oxide (AZO). In another embodiment, the first electrode 300A may include a reflective film including silver (Ag), magnesium (Mg), aluminium (Al), platinum (Pt), palladium (Pd), gold (Au), nickel (Ni), neodymium (Nd), iridium (Ir), chromium (Cr), or a compound thereof. In another embodiment, the first electrode 300A may further include a film formed of ITO, IZO, ZnO, or In₂O₃ over/under the reflective film. The second electrode 300B may include the same or similar material as or to that of the first electrode 300A.

The first hole injection layer 303 may be located on the first electrode 300A and the second electrode 300B. The first hole injection layer 303 may cover the first electrode 300A and the second electrode 300B. In an embodiment, the first hole injection layer 303 may continuously extend from the first electrode 300A to the second electrode 300B. In an embodiment, the first hole injection layer 303 may be located over the entire display area DA. The first hole injection layer 303 may facilitate hole injection.

The first hole transport layer 311 may be located on the first hole injection layer 303. In an embodiment, the first hole transport layer 311 may continuously extend from the first electrode 300A to the second electrode 300B. In an embodiment, the first hole transport layer 311 may be located over the entire display area DA. The first hole transport layer 311 may enable holes transmitted from the first electrode 300A and the second electrode 300B to move to the first emission layer 313A and the second emission layer 313B, and may enable electrons transmitted from the first negative charge generation layer 319 to be confined to the first emission layer 313A and the second emission layer 313B.

The first emission layer 313A and the second emission layer 313B may be located on the first hole transport layer 311. In an embodiment, the first emission layer 313A is located on the first electrode 300A. The first emission layer 313A and the first electrode 300A may overlap each other in a z direction of FIG. 5. The second emission layer 313B is located on the second electrode 300B. The second emission layer 313B and the second electrode 300B may overlap each other in the z direction of FIG. 5. Carriers such as holes and electrons may recombine in the first emission layer 313A and the second emission layer 313B to generate excitons. The excitons may change from an exited state to a ground state to generate light.

In an embodiment, the first emission layer 313A and the second emission layer 313B may emit light of different wavelength bands. In another embodiment, the first emission layer 313A and the second emission layer 313B may emit light of the same wavelength band. In an embodiment, each of the first emission layer 313A and the second emission layer 313B may include an organic material.

The first buffer layer 315 may be located on the first emission layer 313A and the second emission layer 313B. The first buffer layer 315 may continuously extend from the first emission layer 313A to the second emission layer 313B. In an embodiment, the first buffer layer 315 may be located over the entire display area DA. In an embodiment, the first buffer layer 315 may include an electron transporting compound.

The first electron transport layer 317 may be located on the first buffer layer 315. In an embodiment, the first electron transport layer 317 may be located over the entire display area DA. The first electron transport layer 317 may transport electrons from the first negative charge generation layer 319 to the first emission layer 313A and the second emission layer 313B.

The first adhesive pattern WALA1 may be located on the first electron transport layer 317. The first adhesive pattern WALA1 may be located between a center 313CA of the first emission layer 313A and a center 313CB of the second emission layer 313B in a plan view. In an embodiment, the first adhesive pattern WALA1 may be located between the first organic light-emitting diode OLED1 and the second organic light-emitting diode OLED2. The first adhesive pattern WALA1 may be a pattern for adjusting a ratio of a dopant included in the first negative charge generation layer 319 according to a location.

In an embodiment, the first adhesive pattern WALA1 may include a fluoro group. In an embodiment, the first adhesive pattern WALA1 may be formed by using a material such as 8-quinolinolato lithium (Liq), N,N-diphenyl-N,N-bis(9-phenyl-9H-carbazol-3-yl)biphenyl-4,4'-diamine (HT01), N(diphenyl-4-yl)9,9-dimethyl-N-(4(9-phenyl-9H-carbazol-3-yl)phenyl)-9H-fluorene-2-amine (HT211), or 2-(4-(9,10-di(naphthalene-2-yl)anthracene-2-yl)phenyl)-1-phenyl-1H-benzo-[D]imidazole (LG201).

The first negative charge generation layer 319 may be continuously located to cover the first emission layer 313A, the second emission layer 313B, and the first adhesive pattern WALA1. In an embodiment, the first negative charge generation layer 319 may be located over the entire display area DA. In an embodiment, the first negative charge generation layer 319 may be located on the first electron transport layer 317 and the first adhesive pattern WALA1. The first negative charge generation layer 319 may supply electrons to the first emission layer 313A and the second emission layer 313B. In an embodiment, the first negative charge generation layer 319 may be an n-type charge generation layer.

The first negative charge generation layer 319 includes a first overlapping area 319R1 and an outside area 319OR. The first overlapping area 319R1 is an area located between the center 313CA of the first emission layer 313A and the center 313CB of the second emission layer 313B in a plan view. The first overlapping area 319R1 may be an area where the first negative charge generation layer 319 and the first adhesive pattern WALA1 overlap each other. The first negative charge generation layer 319 may directly contact the first adhesive pattern WALA1. In an embodiment, the first negative charge generation layer 319 may directly contact the first adhesive pattern WALA1 in the first overlapping area 319R1.

The outside area 319OR is an area located outside the first overlapping area 319R1. The outside area 319OR may be an area of the first negative charge generation layer 319 other than the first overlapping area 319R1. The outside area 319OR may be an area overlapping the first emission layer 313A and the second emission layer 313B in a plan view.

The first negative charge generation layer 319 includes a host and a dopant. In an embodiment, the host includes an organic material. The dopant includes a metal material. In an embodiment, a mixing ratio of the dopant to the host and the dopant may range from 1% to 99%. In an embodiment, the dopant is provided at a first ratio in the first overlapping area 319R1, and the dopant may be provided at a second ratio in the outside area 319OR. The first ratio may be a ratio of the dopant to the host and the dopant in the first overlapping area 319R1. The second ratio may be a ratio of the dopant to the host and the dopant in the outside area 319OR. In this case, the first ratio is less than the second ratio. In an embodiment, the host may be provided in the first overlapping area 319R1 and the outside area 319OR, and the dopant may be provided in the outside area 319OR. In an embodiment, the dopant may not be located in the first overlapping area 319R1.

In the present embodiment, the first adhesive pattern WALA1 may be located under the first negative charge generation layer 319. When the first negative charge generation layer 319 is formed on the first adhesive pattern WALA1, the dopant of the first negative charge generation layer 319 and the first adhesive pattern WALA1 may have a weak adhesive force therebetween. This may be because surface energy of the first adhesive pattern WALA1 is low. Accordingly, the first ratio may be less than the second ratio, and electrons generated in the outside area 319OR overlapping the first emission layer 313A may not be able to move to the outside area 319OR overlapping the second emission layer 313B. In this case, when the first organic light-emitting diode OLED1 emits light, unintended light emission from the second organic light-emitting diode OLED2 that is adjacent to the first organic light-emitting diode OLED1 may be prevented or reduced. Accordingly, color purity degradation in the display panel 10 may be prevented or reduced.

Because a relatively small amount of dopant including a metal material is located in the first overlapping area 319R1, a light transmittance of the display panel 10 in the first overlapping area 319R1 may increase. Because a relatively small amount of dopant including a metal material is located in the first overlapping area 319R1, a light reflectance of the display panel 10 in the first overlapping area 319R1 may be reduced.

The first positive charge generation layer 320 is located on the first negative charge generation layer 319. The first positive charge generation layer 320 may be continuously located on the first negative charge generation layer 319. In an embodiment, the first positive charge generation layer 320 may be located over the entire display area DA. In an embodiment, the first positive charge generation layer 320 may include a dopant and a host. In an embodiment, the dopant of the first positive charge generation layer 320 and the host of the first positive charge generation layer 320 may be entirely located in the first positive charge generation layer 320. In an embodiment, the first positive charge generation layer 320 may be a p-type charge generation layer. The first positive charge generation layer 320 may supply holes to the first upper emission layer 323A and the second upper emission layer 323B.

The second hole transport layer 321 may be located on the first positive charge generation layer 320. In an embodiment, the second hole transport layer 321 may continuously extend on the first positive charge generation layer 320. In an embodiment, the second hole transport layer 321 may be located over the entire display area DA. The second hole transport layer 321 may enable holes transmitted from the first positive charge generation layer 320 to move to the first upper emission layer 323A and the second upper emission layer 323B, and may enable electrons transmitted from the common electrode 340 to be confined to the first upper emission layer 323A and the second upper emission layer 323B.

The first upper emission layer 323A and the second upper emission layer 323B may be located on the second hole transport layer 321. Carriers such as holes and electrons from the first upper emission layer 323A and the second upper emission layer 323B may recombine to generate excitons. The excitons may change from an excited state to a ground state to generate light. In an embodiment, each of the first upper emission layer 323A and the second upper emission layer 323B may include an organic material.

The first upper emission layer 323A is located on the first positive charge generation layer 320 and overlaps the first emission layer 313A. For example, the first upper emission layer 323A may overlap the first emission layer 313A in the z direction of FIG. 5. In an embodiment, the first upper emission layer 323A may emit light of the same wavelength band as that of the first emission layer 313A. In another embodiment, the first upper emission layer 323A may emit light of a wavelength band different from that of the first emission layer 313A.

The second upper emission layer 323B is located on the first positive charge generation layer 320 and overlaps the second emission layer 313B. For example, the second upper emission layer 323B may overlap the second emission layer 313B in the z direction of FIG. 5. In an embodiment, the second upper emission layer 323B may emit light of the same wavelength band as that of the second emission layer 313B. In another embodiment, the second upper emission layer 323B may emit light of a wavelength band different from that of the second emission layer 313B.

The second buffer layer 325 may be located on the first upper emission layer 323A and the second upper emission layer 323B. The second buffer layer 325 may continuously extend from the first upper emission layer 323A to the second upper emission layer 323B. In an embodiment, the second buffer layer 325 may be located over the entire display area DA. In an embodiment, the second buffer layer 325 may include an electron transporting compound.

The second electron transport layer 327 may be located on the second buffer layer 325. In an embodiment, the second electron transport layer 327 may be located over the entire display area DA. The second electron transport layer 327 may transport electrons from the common electrode 340 to the first upper emission layer 323A and the second upper emission layer 323B.

The common electrode 340 may be located on the second electron transport layer 327. In an embodiment, the common electrode 340 is located on the first upper emission layer 323A and the second upper emission layer 323B. In an embodiment, the common electrode 340 may be located over the entire display area DA. The common electrode 340 may include a conductive material having a low work function. For example, the common electrode 340 may include a (semi)transparent layer including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the common electrode 340 may further include a layer formed of ITO, IZO, ZnO, or In₂O₃ on the (semi)transparent layer including the above material.

The capping layer 350 may be located on the common electrode 340. In an embodiment, the capping layer 350 may be located over the entire display area DA.

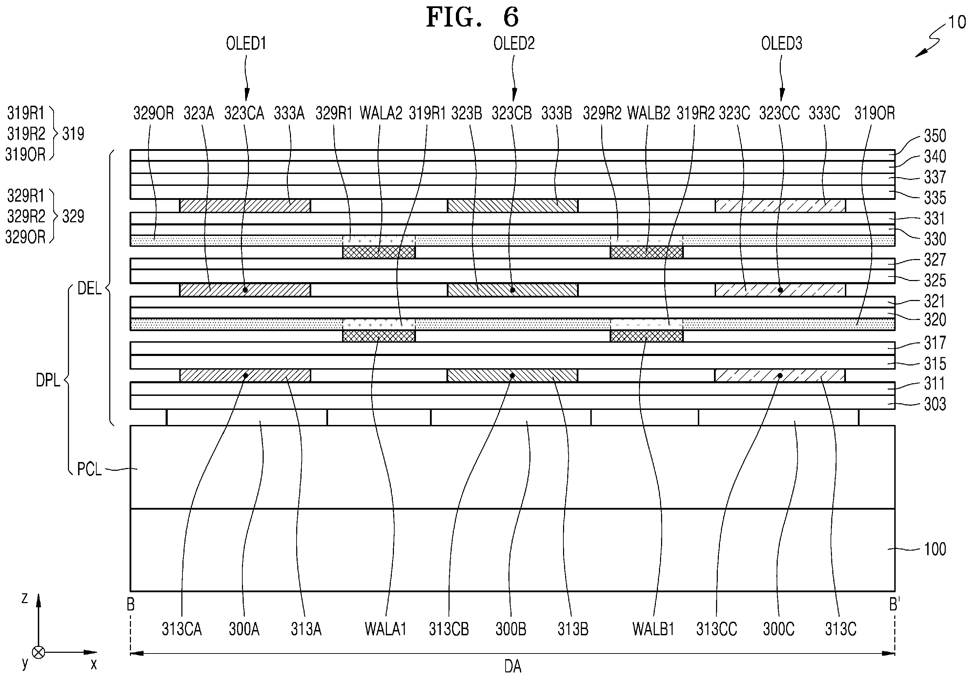

FIG. 6 is a cross-sectional view taken along line B-B' of the display panel 10 of FIG. 3. In FIG. 6, the same members as those of FIG. 5 are denoted by the same reference numerals, and thus a repeated description thereof will be omitted.

Referring to FIG. 6, the display panel 10 may include the substrate 100 and a display layer DPL. In an embodiment, the substrate 100 may include the display area DA. The display layer DPL may be located on the substrate 100. The display layer DPL may include the pixel circuit layer PCL and the display element layer DEL.

The display element layer DEL may be located on the pixel circuit layer PCL. The display element layer DEL may include a display element. In an embodiment, the display element layer DEL may include the first electrode 300A, the second electrode 300B, a third electrode 300C, the first hole injection layer 303, the first stack, the first adhesive pattern WALA1, a second (low) adhesive pattern WALB1, the first negative charge generation layer 319, the first positive charge generation layer 320, the second stack, a first additional (low) adhesive pattern WALA2, a second additional (low) adhesive pattern WALB2, a second negative charge generation layer 329, a second positive charge generation layer 330, a third stack, the common electrode 340, and the capping layer 350. In an embodiment, the first stack may include the first hole transport layer 311, the first emission layer 313A, the second emission layer 313B, a third emission layer 313C, the first buffer layer 315, and the first electron transport layer 317. The second stack may include the second hole transport layer 321, the first upper emission layer 323A, the second upper emission layer 323B, a third upper emission layer 323C, the second buffer layer 325, and the second electron transport layer 327. The third stack may include a third hole transport layer 331, a first additional emission layer 333A, a second additional emission layer 333B, a third additional emission layer 333C, a third buffer layer 335, and a third electron transport layer 337.

In an embodiment, the display element layer DEL may include one third stack. In another embodiment, the display element layer DEL may include a plurality of third stacks. The following will be described in detail assuming that the display element layer DEL includes one third stack.

The first electrode 300A, the first emission layer 313A, the first upper emission layer 323A, the first additional emission layer 333A, and the common electrode 340 may constitute the first organic light-emitting diode OLED1 that is a first display element. The second electrode 300B, the second emission layer 313B, the second upper emission layer 323B, the second additional emission layer 333B, and the common electrode 340 may constitute the second organic light-emitting diode OLED2 that is a second display element. The third electrode 300C, the third emission layer 313C, the third upper emission layer 323C, the third additional emission layer 333C, and the common electrode 340 may constitute the third organic light-emitting diode OLED3 that is a third display element.

Although the display element layer DEL includes the first organic light-emitting diode OLED1, the second organic light-emitting diode OLED2, and the third organic light-emitting diode OLED3 in FIG. 6, in another embodiment, the display element layer DEL may further include a fourth organic light-emitting diode or more. The following will be described in detail assuming that the display element layer DEL includes the first organic light-emitting diode OLED1, the second organic light-emitting diode OLED2, and the third organic light-emitting diode OLED3.

The first electrode 300A, the second electrode 300B, and the third electrode 300C may be located in the display area DA. The second electrode 300B and the third electrode 300C may be located close to each other. In other words, the second electrode 300B and the third electrode 300C may be adjacent to each other. In an embodiment, the first electrode 300A, the second electrode 300B, and the third electrode 300C may respectively supply holes to the first emission layer 313A, the second emission layer 313B, and the third emission layer 313C. Each of the first electrode 300A, the second electrode 300B, and the third electrode 300C may be a pixel electrode. In an embodiment, the third electrode 300C may include the same or similar material as or to that of the first electrode 300A.

The first hole injection layer 303 may be located on the first electrode 300A, the second electrode 300B, and the third electrode 300C. The first hole transport layer 311 may be located on the first hole injection layer 303. The first hole transport layer 311 may enable holes transmitted from the first electrode 300A, the second electrode 300B, and the third electrode 300C to move to the first emission layer 313A, the second emission layer 313B, and the third emission layer 313C, and may enable electrons transmitted from the first negative charge generation layer 319 to be confined to the first emission layer 313A, the second emission layer 313B, and the third emission layer 313C.

The first emission layer 313A, the second emission layer 313B, and the third emission layer 313C may be located on the first hole transport layer 311. The third emission layer 313C may be located on the third electrode 300C. The third emission layer 313C and the third electrode 300C may overlap each other in the z direction of FIG. 6. Carriers such as holes and electrons may recombine in the first emission layer 313A, the second emission layer 313B, and the third emission layer 313C to generate excitons. The excitons may change from an excited state to a ground state to generate light.

In an embodiment, the first emission layer 313A, the second emission layer 313B, and the third emission layer 313C may emit light of different wavelength bands. For example, the first emission layer 313A may emit red light. The second emission layer 313B may emit green light. The third emission layer 313C may emit blue light. In another embodiment, the first emission layer 313A, the second emission layer 313B, and the third emission layer 313C may emit light of the same wavelength band. In an embodiment, each of the first emission layer 313A, the second emission layer 313B, and the third emission layer 313C may include an organic material.

The first buffer layer 315 may be located on the first emission layer 313A, the second emission layer 313B, and the third emission layer 313C. The first electron transport layer 317 may be located on the first buffer layer 315. The first electron transport layer 317 may transport electrons from the first negative charge generation layer 319 to the first emission layer 313A, the second emission layer 313B, and the third emission layer 313C.

The first adhesive pattern WALA1 and the second adhesive pattern WALB1 may be located on the first electron transport layer 317. The first adhesive pattern WALA1 may be located between the center 313CA of the first emission layer 313A and the center 313CB of the second emission layer 313B in a plan view. In an embodiment, the first adhesive pattern WALA1 may be located between the first organic light-emitting diode OLED1 and the second organic light-emitting diode OLED2. The first adhesive pattern WALA1 may be a pattern for adjusting a ratio of a dopant included in the first negative charge generation layer 319 according to a location.

The second adhesive pattern WALB1 may be located between the center 313CB of the second emission layer 313B and a center 313CC of the third emission layer 313C in a plan view. In an embodiment, the second adhesive pattern WALB1 may be located between the second organic light-emitting diode OLED2 and the third organic light-emitting diode OLED3. The second adhesive pattern WALB1 may be a pattern for adjusting a ratio of the dopant included in the first negative charge generation layer 319 according to a location. The second adhesive pattern WALB1 may include the same or similar material as or to that of the first adhesive pattern WALA1.

The first negative charge generation layer 319 may be continuously located to cover the first emission layer 313A, the second emission layer 313B, the third emission layer 313C, the first adhesive pattern WALA1, and the second adhesive pattern WALB1. In an embodiment, the first negative charge generation layer 319 may be continuously located to cover the second emission layer 313B, the second adhesive pattern WALB1, and the third emission layer 313C. In an embodiment, the first negative charge generation layer 319 may be located on the first electron transport layer 317, the first adhesive pattern WALA1, and the second adhesive pattern WALB1. The first negative charge generation layer 319 may supply electrons to the first emission layer 313A, the second emission layer 313B, and the third emission layer 313C.

The first negative charge generation layer 319 may include the first overlapping area 319R1, a second overlapping area 319R2, and the outside area 319OR. The first overlapping area 319R1 may be an area located between the center 313CA of the first emission layer 313A and the center 313CB of the second emission layer 313B. The second overlapping area 319R2 may be an area located between the center 313CB of the second emission layer 313B and the center 313CC of the third emission layer 313C in a plan view. The second overlapping area 319R2 may be an area where the first negative charge generation layer 319 and the second adhesive pattern WALB1 overlap each other.

The first negative charge generation layer 319 may directly contact the first adhesive pattern WALA1 and the second adhesive pattern WALB1. In an embodiment, the first negative charge generation layer 319 may directly contact the first adhesive pattern WALA1 in the first overlapping area 319R1, and may directly contact the second adhesive pattern WALB1 in the second overlapping area 319R2.

The outside area 319OR may be an area located outside the first overlapping area 319R1 and outside the second overlapping area 319R2. The outside area 319OR may be an area other than the first overlapping area 319R1 and the second overlapping area 319R2. The outside area 319OR may be an area overlapping the first emission layer 313A, the second emission layer 313B, and the third emission layer 313C in a plan view.

The first negative charge generation layer 319 may include a host and a dopant. In an embodiment, the host may include an organic material. The dopant may include a metal material. In an embodiment, the dopant may be provided at a first ratio in the first overlapping area 319R1 and the second overlapping area 319R2, and may be provided at a second ratio in the outside area 319OR. The first ratio may be a ratio of the dopant to the host and the dopant in the first overlapping area 319R1 and the second overlapping area 319R2. The second ratio may be a ratio of the dopant to the host and the dopant in the outside area 319OR. In this case, the first ratio may be less than the second ratio. In an embodiment, the host may be provided in the first overlapping area 319R1, the second overlapping area 319R2, and the outside area 319OR, and the dopant may be provided in the outside area 319OR. In an embodiment, the dopant may not be located in the first overlapping area 319R1 and the second overlapping area 319R2.

In the present embodiment, electrons generated in the outside area 319OR overlapping any one of the first emission layer 313A, the second emission layer 313B, and the third emission layer 313C may be unable to move to the outside area 319OR overlapping another one of the first emission layer 313A, the second emission layer 313B, and the third emission layer 313C. Accordingly, when any one of the first organic light-emitting diode OLED1, the second organic light-emitting diode OLED2, and the third organic light-emitting diode OLED3 emits light, unintended light emission from another one of the first organic light-emitting diode OLED1, the second organic light-emitting diode OLED2, and the third organic light-emitting diode OLED3 may be prevented or reduced.

The first positive charge generation layer 320 may be located on the first negative charge generation layer 319. The second hole transport layer 321 may be located on the first positive charge generation layer 320. The second hole transport layer 321 may enable holes transmitted from the first positive charge generation layer 320 to move to the first upper emission layer 323A, the second upper emission layer 323B, and the third upper emission layer 323C, and may enable electrons transmitted from the second negative charge generation layer 329 to be confined to the first upper emission layer 323A, the second upper emission layer 323B, and the third upper emission layer 323C.

The first upper emission layer 323A, the second upper emission layer 323B, and the third upper emission layer 323C may be located on the second hole transport layer 321. Carriers such as holes and electrons may recombine in the first upper emission layer 323A, the second upper emission layer 323B, and the third upper emission layer 323C to generate excitons. The excitons may change from an excited state to a ground state to generate light. In an embodiment, each of the first upper emission layer 323A, the second upper emission layer 323B, and the third upper emission layer 323C may include an organic material.

The first upper emission layer 323A may be located on the first positive charge generation layer 320 and may overlap the first emission layer 313A. The second upper emission layer 323B may be located on the first positive charge generation layer 320 and may overlap the second emission layer 313B.

The third upper emission layer 323C may be located on the first positive charge generation layer 320 and may overlap the third emission layer 313C. For example, the third upper emission layer 323C may overlap the third emission layer 313C in the z direction of FIG. 5. In an embodiment, the third upper emission layer 323C may emit light of the same wavelength band as that of the third emission layer 313C. In another embodiment, the third upper emission layer 323C may emit light of a wavelength band different from that of the third emission layer 313C.

The second buffer layer 325 may be located on the first upper emission layer 323A, the second upper emission layer 323B, and the third upper emission layer 323C. The second electron transport layer 327 may be located on the second buffer layer 325. The second electron transport layer 327 may transport electrons from the second negative charge generation layer 329 to the first upper emission layer 323A, the second upper emission layer 323B, and the third upper emission layer 323C.

The first additional adhesive pattern WALA2 and the second additional adhesive pattern WALB2 may be located on the second electron transport layer 327. The first additional adhesive pattern WALA2 may be located between a center 323CA of the first upper emission layer 323A and a center 323CB of the second upper emission layer 323B in a plan view. The first additional adhesive pattern WALA2 may be located between the first organic light-emitting diode OLED1 and the second organic light-emitting diode OLED2. The first additional adhesive pattern WALA2 may be a pattern for adjusting a ratio of a dopant included in the second negative charge generation layer 329 according to a location.

In an embodiment, the first additional adhesive pattern WALA2 may include a fluoro group. In an embodiment, the first additional adhesive pattern WALA2 may be formed by using a material such as 8-quinolinolato Lithium (Liq), N,N-diphenyl-N,N-bis(9-phenyl-9H-carbazol-3-yl)biphenyl-4,4'-diamine (HT01), N(diphenyl-4-yl)9,9-dimethyl-N-(4(9-phenyl-9H-carbazol-3-yl)phenyl)-9H-fluorene-2-amine (HT211), or 2-(4-(9,10-di(naphthalene-2-yl)anthracene-2-yl)phenyl)-1-phenyl-1H-benzo-[D]imidazole (LG201).

The second additional adhesive pattern WALB2 may be located between the center 323CB of the second upper emission layer 323B and a center 323CC of the third upper emission layer 323C in a plan view. The second additional adhesive pattern WALB2 may be located between the second organic light-emitting diode OLED2 and the third organic light-emitting diode OLED3. The second additional adhesive pattern WALB2 may be a pattern for adjusting a ratio of the dopant included in the second negative charge generation layer 329 according to a location. In an embodiment, the second additional adhesive pattern WALB2 may include the same or similar material as or to that of the first additional adhesive pattern WALA2.

The second negative charge generation layer 329 may be continuously located to cover the first upper emission layer 323A, the second upper emission layer 323B, and the first additional adhesive pattern WALA2. In an embodiment, the second negative charge generation layer 329 may be continuously located to cover the first upper emission layer 323A, the second upper emission layer 323B, the third upper emission layer 323C, the first additional adhesive pattern WALA2, and the second additional adhesive pattern WALB2. In an embodiment, the second negative charge generation layer 329 may be located over the entire display area DA. The second negative charge generation layer 329 may supply electrons to the first upper emission layer 323A, the second upper emission layer 323B, and the third upper emission layer 323C. In an embodiment, the second negative charge generation layer 329 may be an n-type charge generation layer.

The second negative charge generation layer 329 may include a first upper overlapping area 329R1, a second upper overlapping area 329R2, and an upper outside area 329OR. The first upper overlapping area 329R1 may be an area located between the center 323CA of the first upper emission layer 323A and the center 323CB of the second upper emission layer 323B in a plan view. The first upper overlapping area 329R1 may be an area where the second negative charge generation layer 329 and the first additional adhesive pattern WALA2 overlap each other. The second negative charge generation layer 329 may directly contact the first additional adhesive pattern WALA2. In an embodiment, the second negative charge generation layer 329 may directly contact the first additional adhesive pattern WALA2 in the first upper overlapping area 329R1.

The second upper overlapping area 329R2 may be an area located between the center 323CB of the second upper emission layer 323B and the center 323CC of the third upper emission layer 323C in a plan view. The second upper overlapping area 329R2 may be an area where the second negative charge generation layer 329 and the second additional adhesive pattern WALB2 overlap each other. The second negative charge generation layer 329 may directly contact the second additional adhesive pattern WALB2. In an embodiment, the second negative charge generation layer 329 may directly contact the second additional adhesive pattern WALB2 in the second upper overlapping area 329R2.

The upper outside area 329OR may be an area located outside the first upper overlapping area 329R1 and outside the second upper overlapping area 329R2. The upper outside area 329OR may be an area of the second negative charge generation layer 329 other than the first upper overlapping area 329R1 and the second upper overlapping area 329R2. The upper outside area 329OR may be an area overlapping the first upper emission layer 323A, the second upper emission layer 323B, and the third upper emission layer 323C in a plan view.

The second negative charge generation layer 329 may include a host and a dopant, like the first negative charge generation layer 319. In an embodiment, the host may include an organic material. The dopant may include a metal material. In an embodiment, a mixing ratio of the dopant to the host and the dopant may range from 1% to 99%. In an embodiment, the dopant may be provided at a third ratio in the first upper overlapping area 329R1 and the second upper overlapping area 329R2, and may be provided at a fourth ratio in the upper outside area 329OR. The third ratio may be a ratio of the dopant to the host and the dopant in the first upper overlapping area 329R1 and the second upper overlapping area 329R2. The fourth ratio may be a ratio of the dopant to the host and the dopant in the upper outside area 329OR. In this case, the third ratio may be less than the fourth ratio. In an embodiment, the host may be provided in the first upper overlapping area 329R1, the second upper overlapping area 329R2, and the upper outside area 329OR, and the dopant may be provided in the upper outside area 329OR. In an embodiment, the dopant may not be located in the first upper overlapping area 329R1 and the second upper overlapping area 329R2.

In the present embodiment, electrons generated in the upper outside area 329OR overlapping any one of the first upper emission layer 323A, the second upper emission layer 323B, and the third upper emission layer 323C may not be able to move to the upper outside area 329OR overlapping another one of the first upper emission layer 323A, the second upper emission layer 323B, and the third upper emission layer 323C. Accordingly, when any one of the first organic light-emitting diode OLED1, the second organic light-emitting diode OLED2, and the third organic light-emitting diode OLED3 emits light, unintended light emission from another one of the first organic light-emitting diode OLED1, the second organic light-emitting diode OLED2, and the third organic light-emitting diode OLED3 may be prevented or reduced.

The second positive charge generation layer 330 may be located on the second negative charge generation layer 329. The second positive charge generation layer 330 may be continuously located on the second negative charge generation layer 329. In an embodiment, the second positive charge generation layer 330 may be located over the entire display area DA. In an embodiment, the second positive charge generation layer 330 may include a dopant and a host. In an embodiment, the dopant of the second positive charge generation layer 330 and the host of the second positive charge generation layer 330 may be entirely located in the second positive charge generation layer 330. In an embodiment, the second positive charge generation layer 330 may be a p-type charge generation layer. The second positive charge generation layer 330 may supply holes to the first additional emission layer 333A, the second additional emission layer 333B, and the third additional emission layer 333C.

The third hole transport layer 331 may be located on the second positive charge generation layer 330. In an embodiment, the third hole transport layer 331 may continuously extend on the second positive charge generation layer 330. In an embodiment, the third hole transport layer 331 may be located over the entire display area DA. The third hole transport layer 331 may enable holes transmitted from the second positive charge generation layer 330 to move to the first additional emission layer 333A, the second additional emission layer 333B, and the third additional emission layer 333C, and may enable electrons transmitted from the common electrode 340 to be confined to the first additional emission layer 333A, the second additional emission layer 333B, and the third additional emission layer 333C.

The first additional emission layer 333A, the second additional emission layer 333B, and the third additional emission layer 333C may be located on the third hole transport layer 331. Carriers such as holes and electrons may recombine in the first additional emission layer 333A, the second additional emission layer 333B, and the third additional emission layer 333C to generate excitons. The excitons may change from an excited state to a ground state to generate light. In an embodiment, each of the first additional emission layer 333A, the second additional emission layer 333B, and the third additional emission layer 333C may include an organic material.

The first additional emission layer 333A may be located on the second positive charge generation layer 330 and may overlap the first upper emission layer 323A. For example, the first additional emission layer 333A may overlap the first upper emission layer 323A in the z direction of FIG. 6. In an embodiment, the first additional emission layer 333A may emit light of the same wavelength band as that of the first upper emission layer 323A. In another embodiment, the first additional emission layer 333A may emit light of a wavelength band different from that of the first upper emission layer 323A.

The second additional emission layer 333B may be located on the second positive charge generation layer 330 and may overlap the second upper emission layer 323B. For example, the second additional emission layer 333B may overlap the second upper emission layer 323B in the z direction of FIG. 6. In an embodiment, the second additional emission layer 333B may emit light of the same wavelength band as that of the second upper emission layer 323B. In another embodiment, the second additional emission layer 333B may emit light of a wavelength band different from that of the second upper emission layer 323B.

The third additional emission layer 333C may be located on the second positive charge generation layer 330 and may overlap the third upper emission layer 323C. For example, the third additional emission layer 333C may overlap the third upper emission layer 323C in the z direction of FIG. 6. In an embodiment, the third additional emission layer 333C may emit light of the same wavelength band as that of the third upper emission layer 323C. In another embodiment, the third additional emission layer 333C may emit light of a wavelength band different from that of the third upper emission layer 323C.

The third buffer layer 335 may be located on the first additional emission layer 333A, the second additional emission layer 333B, and the third additional emission layer 333C. The third buffer layer 335 may be located over the entire display area DA. The third buffer layer 335 may include an electron transporting compound.

The third electron transport layer 337 may be located on the third buffer layer 335. In an embodiment, the third electron transport layer 337 may be located over the entire display area DA. The third electron transport layer 337 may transport electrons from the common electrode 340 to the first additional emission layer 333A, the second additional emission layer 333B, and the third additional emission layer 333C.

The common electrode 340 may be located on the third electron transport layer 337. The common electrode 340 may be located on the first additional emission layer 333A and the second additional emission layer 333B. In an embodiment, the common electrode 340 may be located on the first additional emission layer 333A, the second additional emission layer 333B, and the third additional emission layer 333C. The capping layer 350 may be located on the common electrode 340.

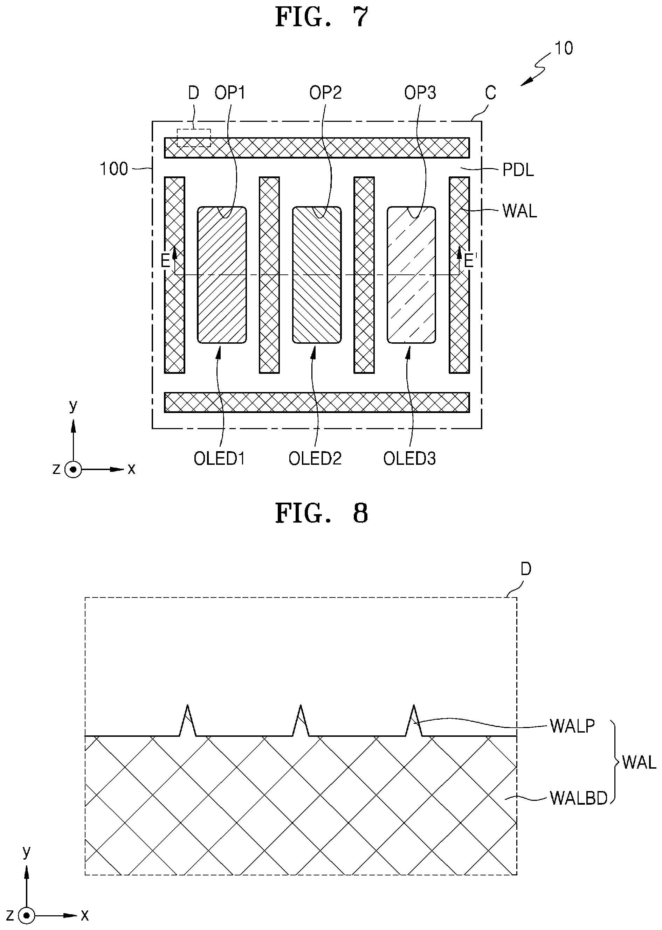

FIG. 7 is an enlarged view illustrating a portion C of the display panel 10 of FIG. 3, according to an embodiment. FIG. 8 is an enlarged view illustrating a portion D of the display panel 10 of FIG. 7. In FIGS. 7 and 8, the same members as those in FIG. 6 are denoted by the same reference numerals, and thus a repeated description thereof will be omitted.

Referring to FIG. 7, the display panel 10 may include the substrate 100, the first organic light-emitting diode OLED1, the second organic light-emitting diode OLED2, the third organic light-emitting diode OLED3, a pixel-defining layer PDL, and an adhesive pattern WAL.

The substrate 100 may include a display area. The first organic light-emitting diode OLED1, the second organic light-emitting diode OLED2, the third organic light-emitting diode OLED3, the pixel-defining layer PDL, and the adhesive pattern WAL may be located in the display area.

In an embodiment, the first organic light-emitting diode OLED1, the second organic light-emitting diode OLED2, and the third organic light-emitting diode OLED3 may be arranged in a stripe shape. For example, the first organic light-emitting diode OLED1, the second organic light-emitting diode OLED2, and the third organic light-emitting diode OLED3 may be arranged parallel to one another in the first direction (e.g., the x direction or the -x direction). In another embodiment, the first organic light-emitting diode OLED1, the second organic light-emitting diode OLED2, and the third organic light-emitting diode OLED3 may be arranged in any of various shapes such as a PenTile Matrix^{™} shape, a mosaic shape, or a delta shape.

The pixel-defining layer PDL may define an emission area of an organic light-emitting diode. In an embodiment, the pixel-defining layer PDL may include a first opening portion OP1, a second opening portion OP2, and a third opening portion OP3. The first opening portion OP1 may define an emission area of the first organic light-emitting diode OLED1. In an embodiment, the first opening portion OP1 may overlap a first electrode of the first organic light-emitting diode OLED1. The second opening portion OP2 may define an emission area of the second organic light-emitting diode OLED2. In an embodiment, the second opening portion OP2 may overlap a second electrode of the second organic light-emitting diode OLED2. The third opening portion OP3 may define an emission area of the third organic light-emitting diode OLED3. In an embodiment, the third opening portion OP3 may overlap a third electrode of the third organic light-emitting diode OLED3.

Although the area of the first opening portion OP1, the area of the second opening portion OP2, and the area of the third opening portion OP3 are the same in FIG. 7, in another embodiment, any one of the area of the first opening portion OP1, the area of the second opening portion OP2, and the area of the third opening portion OP3 may be different from another one of the area of the first opening portion OP1, the area of the second opening portion OP2, and the area of the third opening portion OP3.

Although a shape of the first opening portion OP1, a shape of the second opening portion OP2, and a shape of the third opening portion OP3 are substantially quadrangular shapes in FIG. 7, a shape of the first opening portion OP1, a shape of the second opening portion OP2, and a shape of the third opening portion OP3 may each be any of various shapes such as a polygonal shape, a circular shape, or an elliptical shape.

The adhesive pattern WAL may overlap the pixel-defining layer PDL. The adhesive pattern WAL of FIG. 7 may be at least one of the first adhesive pattern WALA1, the second adhesive pattern WALB1, the first additional adhesive pattern WALA2, and the second additional adhesive pattern WALB2 of FIG. 6.

In an embodiment, the adhesive pattern WAL may be located between the first opening portion OP1 and the second opening portion OP2 in a plan view. The adhesive pattern WAL may be located between the second opening portion OP2 and the third opening portion OP3 in a plan view.

A plurality of adhesive patterns WAL may be provided. In an embodiment, the plurality of adhesive patterns WAL may be spaced apart from one another. The plurality of adhesive patterns WAL may extend in the first direction (e.g., the x direction or the -x direction) and/or the second direction (e.g., the y direction or the -y direction). In an embodiment, the plurality of adhesive patterns WAL may at least partially surround the first opening portion OP1, the second opening portion OP2, and the third opening portion OP3. For example, any one of the plurality of adhesive patterns WAL may at least partially surround a perimeter of at least one of the first opening portion OP1 and the second opening portion OP2.

Referring to FIG. 8, the adhesive pattern WAL may include a body portion WALBD and a protruding portion WALP. In an embodiment, the body portion WALBD of the adhesive pattern WAL may have an irregular speckle shape such as a coral reef shape or a brain shape. The irregular speckle shape may be a shape formed when the adhesive pattern WAL is formed.

The protruding portion WALP of the adhesive pattern WAL may be a portion protruding from the body portion WALBD of the adhesive pattern WAL in a plan view. In an embodiment, a plurality of protruding portions WALP of the adhesive pattern WAL may be provided. Although the protruding portion WALP of the adhesive pattern WAL has a triangular shape in FIG. 8, in another embodiment, the protruding portion WALP of the adhesive pattern WAL may have any of various shapes such as a spike shape or an irregular projection shape. The protruding portion WALP of the adhesive pattern WAL may be formed by a diffusion phenomenon when the adhesive pattern WAL is formed.

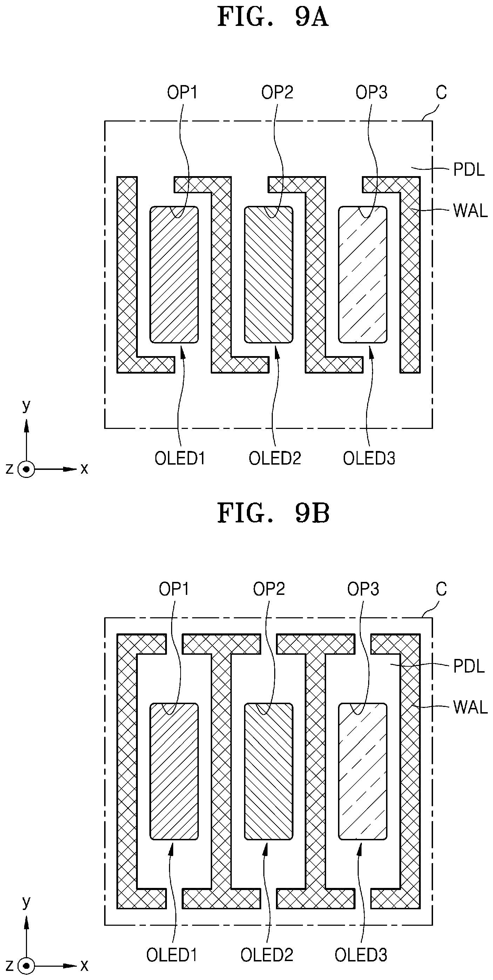

FIGS. 9A through 9D are enlarged views illustrating the portion C of the display panel 10 of FIG. 3, according to various embodiments. In FIGS. 9A through 9D, the same members as those in FIG. 7 are denoted by the same reference numerals, and thus a repeated description thereof will be omitted.

Referring to FIGS. 9A through 9D, the display panel 10 may include the substrate 100, the first organic light-emitting diode OLED1, the second organic light-emitting diode OLED2, the third organic light-emitting diode OLED3, the pixel-defining layer PDL, and the adhesive pattern WAL.

The substrate 100 may include a display area. The first organic light-emitting diode OLED1, the second organic light-emitting diode OLED2, the third organic light-emitting diode OLED3, the pixel-defining layer PDL, and the adhesive pattern WAL may be located in the display area.

The adhesive pattern WAL may overlap the pixel-defining layer PDL. The adhesive pattern WAL of FIGS. 9A through 9D may be at least one of the first adhesive pattern WALA1, the second adhesive pattern WALB 1, the first additional adhesive pattern WALA2, and the second additional adhesive pattern WALB2.

In an embodiment, the adhesive pattern WAL may be located between the first opening portion OP1 and the second opening portion OP2 in a plan view. The adhesive pattern WAL may be located between the second opening portion OP2 and the third opening portion OP3 in a plan view.

Referring to FIGS. 9A and 9B, a plurality of adhesive patterns WAL may be provided. In an embodiment, the plurality of adhesive patterns WAL may be spaced apart from one another. For example, the plurality of adhesive patterns WAL may be spaced apart from one another in the first direction (e.g., the x direction or the -x direction). The plurality of adhesive patterns WAL may at least partially surround the first organic light-emitting diode OLED1, the second organic light-emitting diode OLED2, and the third organic light-emitting diode OLED3. The adhesive pattern WAL may at least partially surround a perimeter of at least one of the first opening portion OP1 and the second opening portion OP2.

Referring to FIG. 9A, one side of the adhesive pattern WAL located between the first opening portion OP1 and the second opening portion OP2 may extend to at least partially surround a perimeter of the first opening portion OP1, and the other side of the adhesive pattern WAL located between the first opening portion OP1 and the second opening portion OP2 may extend to at least partially surround a perimeter of the second opening portion OP2. One side of the adhesive pattern WAL located between the second opening portion OP2 and the third opening portion OP3 may extend to at least partially surround a perimeter of the second opening portion OP2, and the other side of the adhesive pattern WAL located between the second opening portion OP2 and the third opening portion OP3 may extend to at least partially surround a perimeter of the third opening portion OP3.

Referring to FIG. 9B, the adhesive pattern WAL located between the first opening portion OP1 and the second opening portion OP2 may extend to at least partially surround a perimeter of the first opening portion OP1 and a perimeter of the second opening portion OP2. The adhesive pattern WAL located between the second opening portion OP2 and the third opening portion OP3 may extend to at least partially surround a perimeter of the second opening portion OP2 and a perimeter of the third opening portion OP3.

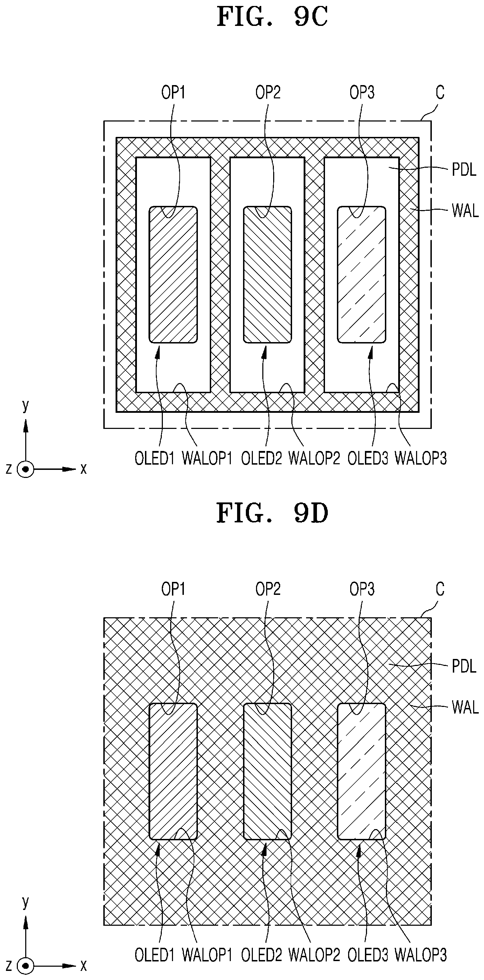

Referring to FIGS. 9C and 9D, the adhesive pattern WAL may entirely surround the first opening portion OP1, the second opening portion OP2, and the third opening portion OP3. In other words, the adhesive pattern WAL may include a first pattern opening portion WALOP1, a second pattern opening portion WALOP2, and a third pattern opening portion WALOP3. The first pattern opening portion WALOP1 and the first opening portion OP1 may overlap each other. The second pattern opening portion WALOP2 and the second opening portion OP2 may overlap each other. The third pattern opening portion WALOP3 and the third opening portion OP3 may overlap each other.

Referring to FIG. 9C, the area of the first pattern opening portion WALOP1 may be greater than the area of the first opening portion OP1. The area of the second pattern opening portion WALOP2 may be greater than the area of the second opening portion OP2. The area of the third pattern opening portion WALOP3 may be greater than the area of the third opening portion OP3.

Referring to FIG. 9D, a shape of the first pattern opening portion WALOP1 may be the same as a shape of the first opening portion OP1. A shape of the second pattern opening portion WALOP2 may be the same as a shape of the second opening portion OP2. A shape of the third pattern opening portion WALOP3 may be the same as a shape of the third opening portion OP3.

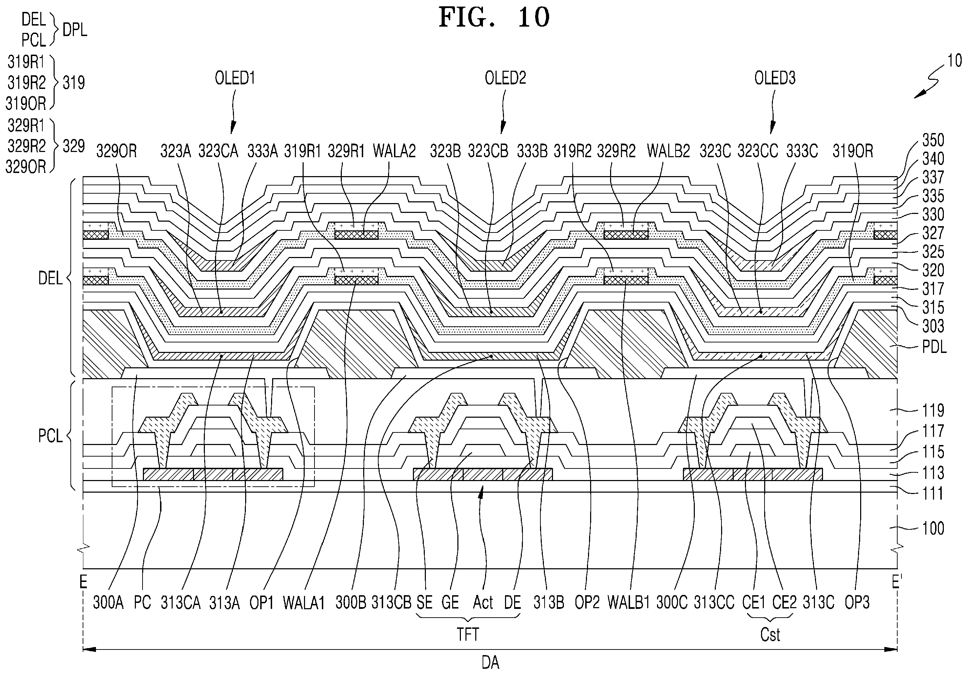

FIG. 10 is a cross-sectional view taken along line E-E' of the display panel 10 of FIG. 7. In FIG. 10, the same members as those in FIG. 6 are denoted by the same reference numerals, and thus a repeated description thereof will be omitted.

Referring to FIG. 10, the display panel 10 may include the substrate 100 and the display layer DPL. In an embodiment, the substrate 100 may include the display area DA. The display layer DPL may be located on the substrate 100. The display layer DPL may include the pixel circuit layer PCL and the display element layer DEL.

The pixel circuit layer PCL may be located on the substrate 100. In an embodiment, a barrier layer (not shown) may be further located between the pixel circuit layer PCL and the substrate 100. The barrier layer for preventing penetration of an external foreign material may have a single or multi-layer structure including an inorganic material such as silicon nitride (SiNₓ) or silicon oxide (SiO₂).

The pixel circuit layer PCL may include the pixel circuit PC, and a buffer layer 111, a first inorganic insulating layer 113, a second inorganic insulating layer 115, a third inorganic insulating layer 117, and an organic insulating layer 119 located under and/or over elements of the pixel circuit PC. A plurality of pixel circuits PC may be provided. The pixel circuit PC may include a thin-film transistor TFT and a storage capacitor Cst.

The buffer layer 111 may be located on the substrate 100. The buffer layer 111 may include an inorganic insulating material such as silicon nitride (SiNₓ), silicon oxynitride (SiON), or silicon oxide (SiO₂), and may have a single or multi-layer structure including the inorganic insulating material.

The thin-film transistor TFT may include a semiconductor layer Act, a gate electrode GE, a source electrode SE, and a drain electrode DE. The semiconductor layer Act may be located on the buffer layer 111. The semiconductor layer Act may include polysilicon. Alternatively, the semiconductor layer Act may include amorphous silicon, an oxide semiconductor, or an organic semiconductor. In an embodiment, the semiconductor layer Act may include a channel region, and a source region and a drain region located on both sides of the channel region.

The gate electrode GE may overlap the channel region of the semiconductor layer Act. The gate electrode GE may include a low-resistance metal material. The gate electrode GE may include a conductive material including molybdenum (Mo), aluminium (Al), copper (Cu), or titanium (Ti), and may have a single or multi-layer structure including the above material.

The first inorganic insulating layer 113 may be located between the semiconductor layer Act and the gate electrode GE. The first inorganic insulating layer 113 may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). Zinc oxide (ZnOₓ) may be zinc oxide (ZnO) and/or zinc peroxide (ZnO₂).

The second inorganic insulating layer 115 may cover the gate electrode GE. The second inorganic insulating layer 115 may include an inorganic insulating material such as silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ), like the first inorganic insulating layer 113.

An upper electrode CE2 of the storage capacitor Cst may be located on the second inorganic insulating layer 115. In an embodiment, the upper electrode CE2 may overlap the gate electrode GE. In this case, the gate electrode GE and the upper electrode CE2 overlapping each other with the second inorganic insulating layer 115 therebetween may constitute the storage capacitor Cst. That is, the gate electrode GE may function as a lower electrode CE1 of the storage capacitor Cst. As such, the storage capacitor Cst and the thin-film transistor TFT may overlap each other. In another embodiment, the storage capacitor Cst and the thin-film transistor TFT may not overlap each other. The upper electrode CE2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single or multi-layer structure including the above material.

The third inorganic insulating layer 117 may cover the upper electrode CE2. The third inorganic insulating layer 117 may include silicon oxide (SiO₂), silicon nitride (SiNₓ), silicon oxynitride (SiON), aluminium oxide (Al₂O₃), titanium oxide (TiO₂), tantalum oxide (Ta₂O₅), hafnium oxide (HfO₂), or zinc oxide (ZnOₓ). The third inorganic insulating layer 117 may have a single or multi-layer structure including the above inorganic insulating material.

Each of the source electrode SE and the drain electrode DE may be located on the third inorganic insulating layer 117. At least one of the source electrode SE and the drain electrode DE may include a material having high conductivity. At least one of the source electrode SE and the drain electrode DE may include a conductive material including molybdenum (Mo), aluminium (Al), copper (Cu), or titanium (Ti), and may have a single or multi-layer structure including the above material. In an embodiment, at least one of the source electrode SE and the drain electrode DE may have a multi-layer structure including Ti/Al/Ti.

The organic insulating layer 119 may include an organic material. The organic insulating layer 119 may include an organic insulating material such as a general-purpose polymer (e.g., polymethyl methacrylate (PMMA) or polystyrene (PS)), a polymer derivative having a phenol-based group, an acrylic polymer, an imide-based polymer, an aryl ether-based polymer, an amide-based polymer, a fluorinated polymer, a p-xylene-based polymer, a vinyl alcohol-based polymer, or a blend thereof.

The display element layer DEL may be located on the pixel circuit layer PCL. The display element layer DEL may include a display element. In an embodiment, the display element layer DEL may include the first electrode 300A, the second electrode 300B, the third electrode 300C, the pixel-defining layer PDL, the first hole injection layer 303, the first stack, the first adhesive pattern WALA1, the second adhesive pattern WALB1, the first negative charge generation layer 319, the first positive charge generation layer 320, the second stack, the first additional adhesive pattern WALA2, the second additional adhesive pattern WALB2, the second negative charge generation layer 329, the second positive charge generation layer 330, the third stack, the common electrode 340, and the capping layer 350. In an embodiment, the first stack may include the first emission layer 313A, the second emission layer 313B, the third emission layer 313C, the first buffer layer 315, and the first electron transport layer 317. The second stack may include the first upper emission layer 323A, the second upper emission layer 323B, the third upper emission layer 323C, the second buffer layer 325, and the second electron transport layer 327. The third stack may include the first additional emission layer 333A, the second additional emission layer 333B, the third additional emission layer 333C, the third buffer layer 335, and the third electron transport layer 337.

The first electrode 300A, the second electrode 300B, and the third electrode 300C may be located in the display area DA. In an embodiment, each of the first electrode 300A, the second electrode 300B, and the third electrode 300C may be located on the organic insulating layer 119. Each of the first electrode 300A, the second electrode 300B, and the third electrode 300C may be electrically connected to the pixel circuit PC through a contact hole provided in the organic insulating layer 119.

The pixel-defining layer PDL may be located on the first electrode 300A, the second electrode 300B, the third electrode 300C, and the organic insulating layer 119. The pixel-defining layer PDL may include the first opening portion OP1, the second opening portion OP2, and the third opening portion OP3. The first opening portion OP1 may overlap the first electrode 300A. The first opening portion OP1 may expose a central portion of the first electrode 300A. The second opening portion OP2 may overlap the second electrode 300B. The second opening portion OP2 may expose a central portion of the second electrode 300B. The third opening portion OP3 may overlap the third electrode 300C. The third opening portion OP3 may expose a central portion of the third electrode 300C. The pixel-defining layer PDL may include an organic insulating material and/or an inorganic insulating material. In some embodiments, the pixel-defining layer PDL may be a black pixel-defining layer.

The first hole injection layer 303 may be located on the first electrode 300A, the second electrode 300B, the third electrode 300C, and the pixel-defining layer PDL. The first hole injection layer 303 may extend along shapes of the first electrode 300A, the second electrode 300B, the third electrode 300C, and the pixel-defining layer PDL.

The first emission layer 313A, the second emission layer 313B, and the third emission layer 313C may be located on the first hole injection layer 303. In an embodiment, the first emission layer 313A may overlap the first opening portion OP1. The second emission layer 313B may overlap the second opening portion OP2. The third emission layer 313C may overlap the third opening portion OP3.

The first buffer layer 315 may be located on the first emission layer 313A, the second emission layer 313B, and the third emission layer 313C. The first electron transport layer 317 may be located on the first buffer layer 315.

The first adhesive pattern WALA1 and the second adhesive pattern WALB1 may be located on the first electron transport layer 317. The first adhesive pattern WALA1 may be located between the center 313CA of the first emission layer 313A and the center 313CB of the second emission layer 313B in a plan view. The second adhesive pattern WALB1 may be located between the center 313CB of the second emission layer 313B and the center 313CC of the third emission layer 313C in a plan view. The first adhesive pattern WALA1 and the second adhesive pattern WALB1 may overlap the pixel-defining layer PDL.

The first negative charge generation layer 319 may be continuously located to cover the first emission layer 313A, the second emission layer 313B, the third emission layer 313C, the first adhesive pattern WALA1, and the second adhesive pattern WALB1. The first positive charge generation layer 320 may be located on the first negative charge generation layer 319.

The first upper emission layer 323A, the second upper emission layer 323B, and the third upper emission layer 323C may be located on the first positive charge generation layer 320. The first upper emission layer 323A, the second upper emission layer 323B, and the third upper emission layer 323C may respectively overlap the first emission layer 313A, the second emission layer 313B, and the third emission layer 313C.

The second buffer layer 325 may be located on the first upper emission layer 323A, the second upper emission layer 323B, and the third upper emission layer 323C. The second electron transport layer 327 may be located on the second buffer layer 325.

The first additional adhesive pattern WALA2 and the second additional adhesive pattern WALB2 may be located on the second electron transport layer 327. The first additional adhesive pattern WALA2 may overlap the first adhesive pattern WALA1. The second additional adhesive pattern WALB2 may overlap the second adhesive pattern WALB1.

The second negative charge generation layer 329 may be continuously located to cover the first upper emission layer 323A, the second upper emission layer 323B, the third upper emission layer 323C, the first additional adhesive pattern WALA2, and the second additional adhesive pattern WALB2. The second positive charge generation layer 330 may be located on the second negative charge generation layer 329.

The first additional emission layer 333A, the second additional emission layer 333B, and the third additional emission layer 333C may be located on the second positive charge generation layer 330. The first additional emission layer 333A, the second additional emission layer 333B, and the third additional emission layer 333C may respectively overlap the first upper emission layer 323A, the second upper emission layer 323B, and the third upper emission layer 323C.

The third buffer layer 335 may be located on the first additional emission layer 333A, the second additional emission layer 333B, and the third additional emission layer 333C. The third electron transport layer 337 may be located on the third buffer layer 335. The common electrode 340 may be located on the third electron transport layer 337. The capping layer 350 may be located on the common electrode 340.

Although not shown in FIG. 10, an encapsulation layer may be located on the capping layer 350. In an embodiment, the encapsulation layer may include at least one inorganic encapsulation layer and at least one organic encapsulation layer. In an embodiment, the encapsulation layer may include a first inorganic encapsulation layer, an organic encapsulation layer, and a second inorganic encapsulation layer which are sequentially stacked.

Each of the first inorganic encapsulation layer and the second inorganic encapsulation layer may include at least one inorganic material from among aluminium oxide (Al₂O₃), titanium oxide (TiO₂), tantalum oxide (Ta₂O₅), hafnium oxide (HfO₂), zinc oxide (ZnOₓ), silicon oxide (SiO₂), silicon nitride (SiNₓ), and silicon oxynitride (SiON). The organic encapsulation layer may include a polymer-based material. Examples of the polymer-based material may include an acrylic resin, an epoxy resin, polyimide, and polyethylene. In an embodiment, the organic encapsulation layer may include acrylate.

In another embodiment, the encapsulation layer may include an encapsulation substrate. The encapsulation substrate may be a transparent member. The encapsulation substrate may include glass. In this case, the substrate 100 and the encapsulation substrate may be coupled to each other by using a sealing member located in a non-display area.

Although not shown in FIG. 10, a touch electrode layer may be located on the encapsulation layer. The touch electrode layer may obtain coordinate information according to an external input, for example, a touch event.

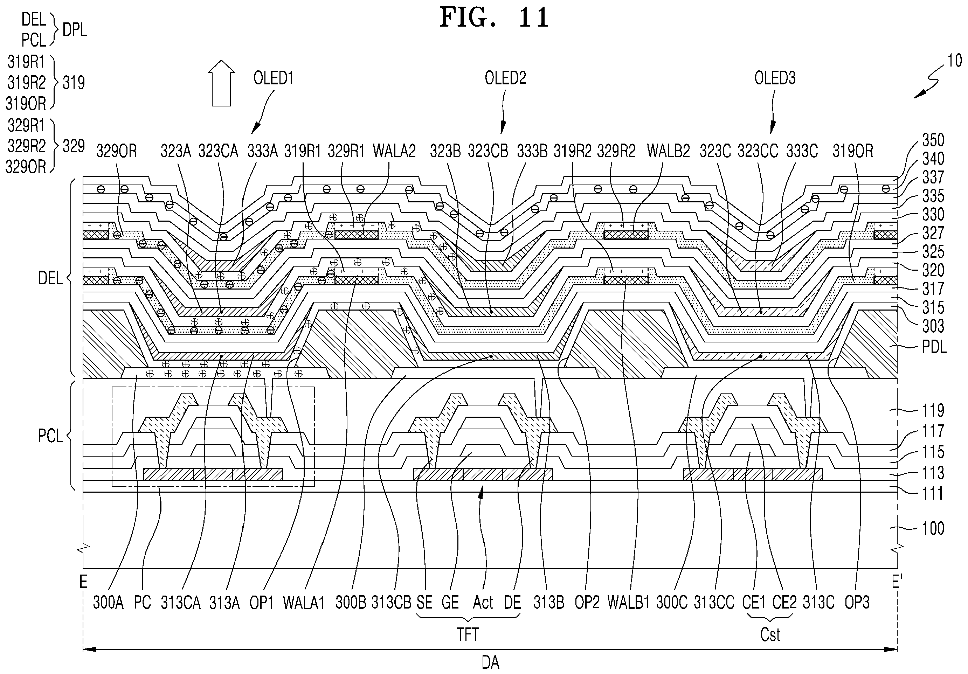

FIG. 11 is a cross-sectional view illustrating that the first organic light-emitting diode OLED1 emits light in the display panel 10 of FIG. 10. In FIG. 11, the same members as those illustrated in FIG. 10 are denoted by the same reference numerals, and thus a repeated description thereof will be omitted.

Referring to FIG. 11, a second power supply voltage may be applied to the common electrode 340. The second power supply voltage may be entirely applied to the common electrode 340. Accordingly, the second power supply voltage may be entirely applied to the common electrode 340 overlapping the display area DA.

The pixel circuit PC electrically connected to the first organic light-emitting diode OLED1 may apply a voltage to the first electrode 300A of the first organic light-emitting diode OLED1. In an embodiment, the first electrode 300A may supply holes to the first emission layer 313A. The first negative charge generation layer 319 may supply electrons to the first emission layer 313A. Carriers such as holes and electrons may recombine in the first emission layer 313A to generate excitons, and the excitons may change from an excited state to a ground state to generate light. In an embodiment, the first positive charge generation layer 320 may supply holes to the first upper emission layer 323A. The second negative charge generation layer 329 may supply electrons to the first upper emission layer 323A. Carriers such as holes and electrons may recombine in the first upper emission layer 323A to generate excitons, and the excitons may change from an excited state to a ground state to generate light. In an embodiment, the second positive charge generation layer 330 may supply holes to the first additional emission layer 333A. The common electrode 340 may supply electrons to the first additional emission layer 333A. Carriers such as holes and electrons may recombine in the first additional emission layer 333A to generate excitons, and the excitons may change from an excited state to a ground state to generate light. Accordingly, the first organic light-emitting diode OLED1 may emit light.

In the present embodiment, the first negative charge generation layer 319 may be continuously located to cover the first emission layer 313A, the second emission layer 313B, and the first adhesive pattern WALA1. A dopant of the first negative charge generation layer 319 may be provided at a first ratio in the first overlapping area 319R1 overlapping the first adhesive pattern WALA1, and may be provided at a second ratio in the outside area 319OR of the first overlapping area 319R1. In this case, the first ratio may be less than the second ratio. In this case, the dopant may include a metal material having high conductivity for carrier movement.

Unlike in the present embodiment, in the case that a dopant of the first negative charge generation layer 319 has a uniform ratio in the display area DA, when the first negative charge generation layer 319 supplies electrons to the first emission layer 313A, the electrons supplied by the first negative charge generation layer 319 may move to the second emission layer 313B that is adjacent to the first emission layer 313A. That is, lateral leakage may occur, and the second organic light-emitting diode OLED2 that is adjacent to the first organic light-emitting diode OLED1 may emit light. Accordingly, color purity degradation in a display apparatus and/or a display panel may occur.

In the present embodiment, however, a dopant of the first negative charge generation layer 319 may be provided at a first ratio in the first overlapping area 319R1 overlapping the first adhesive pattern WALA1 and may be provided at a second ratio in the outside area 319OR of the first overlapping area 319R1. In this case, the first ratio may be less than the second ratio. The first overlapping area 319R1 may be a short-circuit area, and electrons generated in the outside area 319OR overlapping the first emission layer 313A may be unable to move to the outside area 319OR overlapping the second emission layer 313B. Accordingly, lateral leakage may not occur. Such an action may be equally or similarly applied to the second negative charge generation layer 329 overlapping the first additional adhesive pattern WALA2.

In the present embodiment, when the first organic light-emitting diode OLED1 emits light, unintended light emission from the second organic light-emitting diode OLED2 that is adjacent to the first organic light-emitting diode OLED1 may be prevented or reduced. Accordingly, color purity degradation in the display panel 10 may be prevented or reduced. Also, because an interval between the first organic light-emitting diode OLED1 and the second organic light-emitting diode OLED2 provided in the display panel 10 may be reduced, the display panel 10 and/or the display apparatus may have a high resolution.

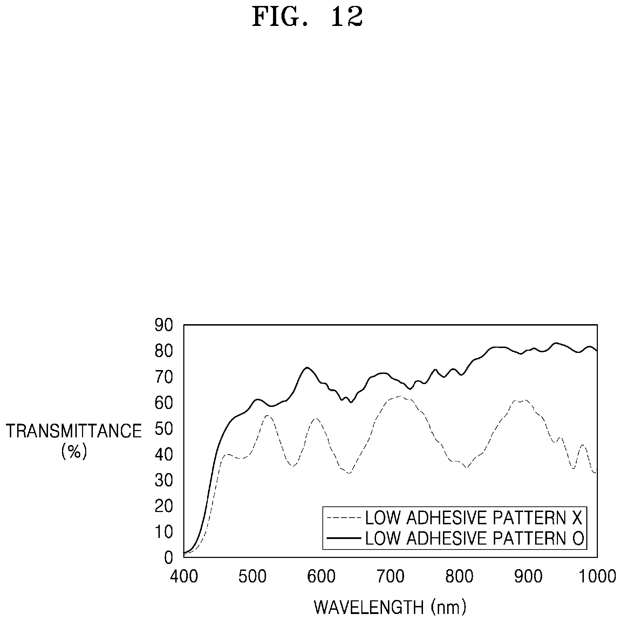

FIG. 12 is a graph illustrating a light transmittance of a display panel of an embodiment and a light transmittance of a display panel of a comparative example that does not include an adhesive pattern (indicated as "LOW ADHESIVE PATTERN X").

Referring to FIG. 12, the display panel of the embodiment is a display panel that includes an adhesive pattern located between adjacent organic light-emitting diodes, and the display panel of the comparative example is a display panel that does not include an adhesive pattern between adjacent organic light-emitting diodes. In this case, a dopant including a metal material of a negative charge generation layer may be small in or may not be distributed on the adhesive pattern located between adjacent organic light-emitting diodes. Accordingly, a light transmittance of the display panel between adjacent organic light-emitting diodes in the embodiment may be higher than a light transmittance of the display panel between adjacent organic light-emitting diodes in the comparative example. For example, in the embodiment, an average light transmittance of the display panel between adjacent organic light-emitting diodes in the embodiment may be 54.6%. An average light transmittance of the display panel between adjacent organic light-emitting diodes in the comparative example may be 38%.

Also, a light reflectance of the display panel between adjacent organic light-emitting diodes in the embodiment may be lower than a light reflectance of the display panel between adjacent organic light-emitting diodes in the comparative example.

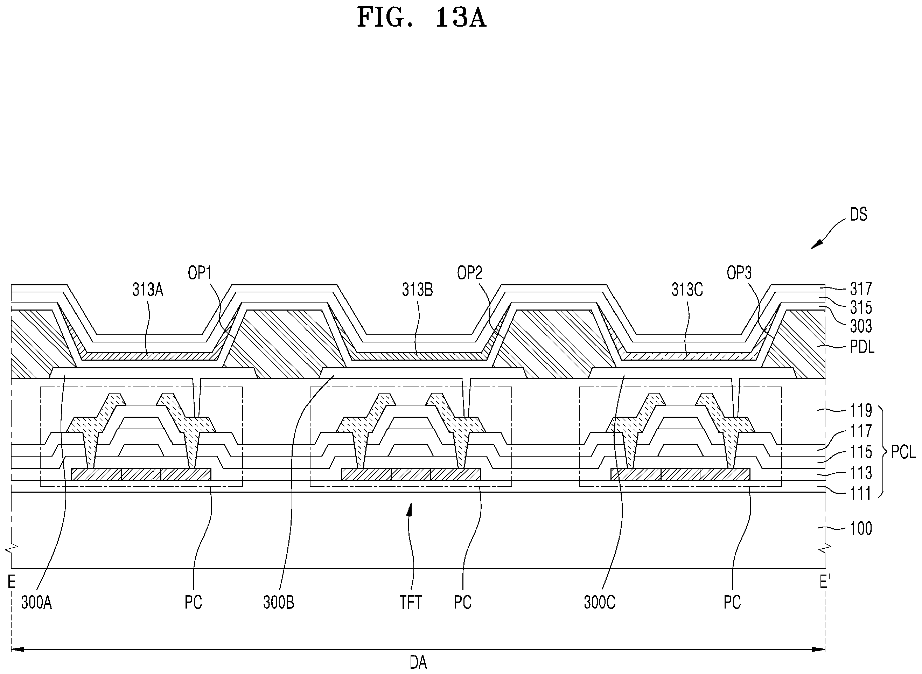

FIGS. 13A through 13C are cross-sectional views illustrating a method of manufacturing a display apparatus, according to an embodiment. In FIGS. 13A through 13C, the same members as those in FIG. 10 are denoted by the same reference numerals, and thus a repeated description thereof will be omitted.

Referring to FIG. 13A, a display substrate DS may be prepared. In an embodiment, the display substrate DS may include the substrate 100, the pixel circuit layer PCL, the first electrode 300A, the second electrode 300B, the third electrode 300C, the pixel-defining layer PDL, the first hole injection layer 303, the first emission layer 313A, the second emission layer 313B, the third emission layer 313C, the first buffer layer 315, and the first electron transport layer 317.

The substrate 100 may include the display area DA. The pixel circuit layer PCL may be located on the substrate 100. The pixel circuit layer PCL may include the pixel circuit PC. The pixel circuit PC may include the thin-film transistor TFT.

The first electrode 300A, the second electrode 300B, and the third electrode 300C may be located on the pixel circuit layer PCL. The first electrode 300A, the second electrode 300B, and the third electrode 300C may be located in the display area DA. The first electrode 300A and the second electrode 300B may be adjacent to each other, and the second electrode 300B and the third electrode 300C may be adjacent to each other.

The pixel-defining layer PDL may be located on the first electrode 300A, the second electrode 300B, the third electrode 300C, and the organic insulating layer 119. The pixel-defining layer PDL may include the first opening portion OP1, the second opening portion OP2, and the third opening portion OP3. The first opening portion OP1 may overlap the first electrode 300A. The first opening portion OP1 may expose a central portion of the first electrode 300A. The second opening portion OP2 may overlap the second electrode 300B. The second opening portion OP2 may expose a central portion of the second electrode 300B. The third opening portion OP3 may overlap the third electrode 300C. The third opening portion OP3 may expose a central portion of the third electrode 300C.

The first hole injection layer 303 may be located on the first electrode 300A, the second electrode 300B, the third electrode 300C, and the pixel-defining layer PDL. The first hole injection layer 303 may extend along shapes of the first electrode 300A, the second electrode 300B, the third electrode 300C, and the pixel-defining layer PDL.

The first emission layer 313A, the second emission layer 313B, and the third emission layer 313C may be located on the first hole injection layer 303. In an embodiment, the first emission layer 313A may overlap the first opening portion OP1. The second emission layer 313B may overlap the second opening portion OP2. The third emission layer 313C may overlap the third opening portion OP3.

The first buffer layer 315 may be located on the first emission layer 313A, the second emission layer 313B, and the third emission layer 313C. The first electron transport layer 317 may be located on the first buffer layer 315.

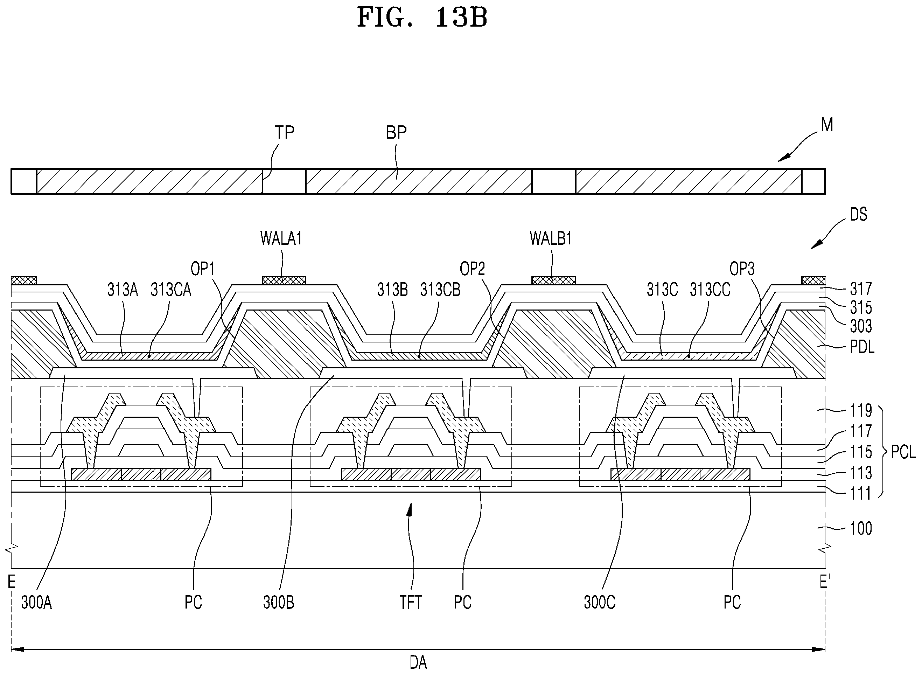

Referring to FIG. 13B, the first adhesive pattern WALA1 and the second adhesive pattern WALB1 may be formed. The first adhesive pattern WALA1 may be formed between the center 313CA of the first emission layer 313A and the center 313CB of the second emission layer 313B in a plan view. The second adhesive pattern WALB1 may be formed between the center 313CB of the second emission layer 313B and the center 313 CC of the third emission layer 313C in a plan view. The first adhesive pattern WALA1 and the second adhesive pattern WALB1 may overlap the pixel-defining layer PDL.

The first adhesive pattern WALA1 and the second adhesive pattern WALB1 may be formed by using a mask M. First, the mask M may be located on the display substrate DS. The mask M may include a blocking portion BP and a transmitting portion TP. The blocking portion BP may be a body of the mask M. The blocking portion BP may overlap the center 313CA of the first emission layer 313A, the center 313CB of the second emission layer 313B, and the center 313CC of the third emission layer 313C. In an embodiment, the blocking portion BP may overlap the first opening portion OP1, the second opening portion OP2, and the third opening portion OP3. The transmitting portion TP may be an opening portion of the mask M. In an embodiment, a plurality of transmitting portions TP may be provided. Any one of the plurality of transmitting portions TP may be located between the center 313CA of the first emission layer 313A and the center 313CB of the second emission layer 313B. In an embodiment, any one of the plurality of transmitting portions TP may be located between the first opening portion OP1 and the second opening portion OP2. Another one of the plurality of transmitting portions TP may be located between the center 313CB of the second emission layer 313B and the center 313CC of the third emission layer 313C. In an embodiment, another one of the plurality of transmitting portions TP may be located between the second opening portion OP2 and the third opening portion OP3. Next, the first adhesive pattern WALA1 and the second adhesive pattern WALB1 may be formed. In other words, the first adhesive pattern WALA1 and the second adhesive pattern WALB1 may be formed by using a fine metal mask (FMM).

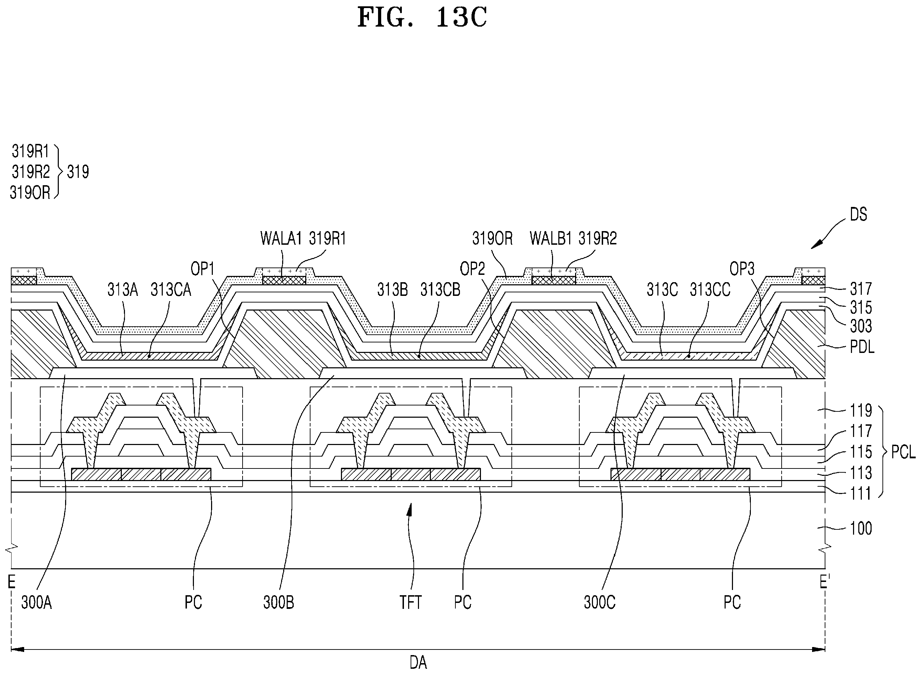

Referring to FIG. 13C, the first negative charge generation layer 319 may be formed. The first negative charge generation layer 319 may be continuously located to cover the first emission layer 313A, the second emission layer 313B, the third emission layer 313C, the first adhesive pattern WALA1, and the second adhesive pattern WALB1. In an embodiment, the first negative charge generation layer 319 may be located over the entire display area DA.

The first negative charge generation layer 319 may include the first overlapping area 319R1, the second overlapping area 319R2, and the outside area 319OR. The first overlapping area 319R1 may be an area located between the center 313CA of the first emission layer 313A and the center 313CB of the second emission layer 313B in a plan view. The second overlapping area 319R2 may be an area located between the center 313CB of the second emission layer 313B and the center 313CC of the third emission layer 313C in a plan view.

The first negative charge generation layer 319 may directly contact the first adhesive pattern WALA1 and the second adhesive pattern WALB1. In an embodiment, the first negative charge generation layer 319 may directly contact the first adhesive pattern WALA1 in the first overlapping area 319R1, and may directly contact the second adhesive pattern WALB1 in the second overlapping area 319R2.

The outside area 319OR may be an area located outside the first overlapping area 319R1 and outside the second overlapping area 319R2. The outside area 319OR may be an area other than the first overlapping area 319R1 and the second overlapping area 319R2. The outside area 319OR may be an area overlapping the first emission layer 313A, the second emission layer 313B, and the third emission layer 313C in a plan view.

The first negative charge generation layer 319 may include a host and a dopant. In an embodiment, the host may include an organic material. The dopant may include a metal material. In an embodiment, the dopant may be provided at a first ratio in the first overlapping area 319R1 and the second overlapping area 319R2, and may be provided at a second ratio in the outside area 319OR. In this case, the first ratio may be less than the second ratio. In an embodiment, the host may be provided in the first overlapping area 319R1, the second overlapping area 319R2, and the outside area 319OR, and the dopant may be provided in the outside area 319OR. In an embodiment, the dopant may not be located in the first overlapping area 319R1 and the second overlapping area 319R2. When the first negative charge generation layer 319 is formed on the first adhesive pattern WALA1 and the second adhesive pattern WALB1, the dopant of the first negative charge generation layer 319 and the first adhesive pattern WALA1 and the second adhesive pattern WALB1 may have a weak adhesive force therebetween. This is because surface energy of the first adhesive pattern WALA1 and surface energy of the second adhesive pattern WALB1 are low. Accordingly, when the first negative charge generation layer 319 is formed, a ratio of the dopant included in the first negative charge generation layer 319 may be adjusted without an additional process.

As described above, a display apparatus according to an embodiment may include an adhesive pattern located between the center of a first emission layer and the center of a second emission layer, and may include a negative charge generation layer continuously located to cover the first emission layer, the second emission layer, and the adhesive pattern. In this case, when the first emission layer emits light, unintended light emission from the second emission layer that is adjacent to the first emission layer may be prevented or reduced due to the negative charge generation layer that is continuously located. Accordingly, color purity degradation in a display apparatus according to an embodiment may be prevented or reduced.

## Claims

1. A display apparatus (1) comprising:
a substrate (100) comprising a display area (DA);
a first electrode (300A) disposed in the display area (DA);
a second electrode (300B) disposed in the display area (DA) to be adjacent to the first electrode (300A);
a first emission layer (313A) disposed on the first electrode (300A);
a second emission layer (313B) disposed on the second electrode (300B);
a first negative charge generation layer (319) continuously disposed to cover the first emission layer (313A) and the second emission layer (313B) and comprising a host comprising an organic material and a dopant comprising a metal material;
a first positive charge generation layer (320) disposed on the first negative charge generation layer (319);
a first upper emission layer (323A) disposed on the first positive charge generation layer (320) and overlapping the first emission layer (313A);
a second upper emission layer (323B) disposed on the first positive charge generation layer (320) and overlapping the second emission layer (313B); and
a common electrode (340) disposed on the first upper emission layer (323A) and the second upper emission layer (323B),
**characterized in that**
the dopant is provided at a first ratio in an overlapping area (319R1, 319R2) of the first negative charge generation layer (319) disposed between a center (313CA) of the first emission layer (313A) and a center (313CB) of the second emission layer (313B) in a plan view, and
the dopant is provided at a second ratio in an outside area (319OR) of the first negative charge generation layer (319) disposed outside the overlapping area (319R1, 319R2),
wherein the first ratio is less than the second ratio.

2. The display apparatus (1) of claim 1, wherein the host is provided in the overlapping area (319R1, 319R2) and the outside area (319OR), and
the dopant is provided in the outside area (319OR).

3. The display apparatus (1) of claim 1 or claim 2, further comprising a first adhesive pattern (WALA1) disposed in the overlapping area (319R1, 319R2),
wherein the first negative charge generation layer (319) is continuously disposed to further cover the first adhesive pattern (WALA1), optionally wherein the first negative charge generation layer (319) and the first adhesive pattern (WALA1) directly contact each other.

4. The display apparatus (1) of claim 3, further comprising:
a third electrode (300C) disposed in the display area (DA) to be adjacent to the second electrode (300B);
a third emission layer (313C) disposed on the third electrode (300C);
a second adhesive pattern (WALB1) disposed between the center (313CB) of the second emission layer (313B) and a center (313CC) of the third emission layer (313C) in a plan view; and
a third upper emission layer (323C) overlapping the third emission layer (313C),
wherein the first negative charge generation layer (319) is continuously disposed to further cover the second adhesive pattern (WALB1), and the third emission layer (313C), and
the common electrode (340) is further disposed on the third upper emission layer (323C), optionally wherein the first emission layer (313A) emits red light,
the second emission layer (313B) emits green light, and
the third emission layer (313C) emits blue light.

5. The display apparatus (1) of any one of claims 1 to 4, further comprising:
a first additional adhesive pattern (WALA2) disposed between a center (313CA) of the first upper emission layer (323A) and a center (313CB) of the second upper emission layer (323B) in a plan view;
a second negative charge generation layer (329) continuously disposed to cover the first upper emission layer (323A), the second upper emission layer (323B), and the first additional adhesive pattern (WALA2);
a second positive charge generation layer (330) disposed on the second negative charge generation layer (329);
a first additional emission layer (333A) disposed on the second positive charge generation layer (330) and overlapping the first upper emission layer (323A); and
a second additional emission layer (333B) disposed on the second positive charge generation layer (330) and overlapping the second upper emission layer (323B),
wherein the common electrode (340) is further disposed on the first additional emission layer (333A) and the second additional emission layer (333B).

6. The display apparatus (1) of any one of claims 1 to 5, further comprising a pixel-defining layer (PDL) comprising a first opening portion (OP1) overlapping the first electrode (300A) and a second opening portion (OP2) overlapping the second electrode (300B),
wherein the first adhesive pattern (WALA1) is disposed between the first opening portion (OP1) and the second opening portion (OP2) in a plan view, optionally wherein the first adhesive pattern (WALA1) at least partially surrounds a perimeter of at least one of the first opening portion (OP1) and the second opening portion (OP2).

7. The display apparatus (1) of any one of claims 1 to 6, wherein the first adhesive pattern (WALA1) comprises a fluoro group,

8. The display apparatus (1) of claim 1 further comprising:
a first adhesive pattern (WALA1) disposed between a center (313CA) of the first emission layer (313A) and a center (313CB) of the second emission layer (313B) in a plan view;
wherein the first negative charge generation layer (319) is continuously disposed to cover the first adhesive pattern (WALA1); and
wherein the dopant overlaps the first adhesive pattern (WALA1).

9. The display apparatus (1) of claim 8, wherein the host is provided in the overlapping area (319R1, 319R2) and the outside area (319OR), and
the dopant is provided in the outside area (319OR).

10. The display apparatus (1) of claim 8 or claim 9, wherein the first negative charge generation layer (319) and the first adhesive pattern (WALA1) directly contact each other.

11. The display apparatus (1) of any one of claims 8 to 10, further comprising:
a third electrode (300C) disposed in the display area (DA) to be adjacent to the second electrode (300B);
a third emission layer (313C) disposed on the third electrode (300C);
a second adhesive pattern (WALB1) disposed between the center (313CB) of the second emission layer (313B) and a center (313CC) of the third emission layer (313C) in a plan view; and
a third upper emission layer (323C) overlapping the third emission layer (313C),
wherein the first negative charge generation layer (319) is continuously disposed to further cover the second adhesive pattern (WALB1) and the third emission layer (313C), and
the common electrode (340) is further disposed on the third upper emission layer (323C), optionally wherein the first emission layer (313A) emits red light,
the second emission layer (313B) emits green light, and
the third emission layer (313C) emits blue light.

12. The display apparatus (1) of any one of claims 8 to 11, further comprising:
a first additional adhesive pattern (WALA2) disposed between a center (313CA) of the first upper emission layer (323A) and a center (313CB) of the second upper emission layer (323B) in a plan view;
a second negative charge generation layer (329) continuously disposed to cover the first upper emission layer (323A), the second upper emission layer (323B), and the first additional adhesive pattern (WALA2);
a second positive charge generation layer (330) disposed on the second negative charge generation layer (329);
a first additional emission layer (333A) disposed on the second positive charge generation layer (330) and overlapping the first upper emission layer (323A); and
a second additional emission layer (333B) disposed on the second positive charge generation layer (330) and overlapping the second upper emission layer (323B),
wherein the common electrode (340) is further disposed on the first additional emission layer (333A) and the second additional emission layer (333B).

13. The display apparatus (1) of any one of claims 8 to 12, further comprising a pixel-defining layer (PDL) comprising a first opening portion (OP1) overlapping the first electrode (300A) and a second opening portion (OP2) overlapping the second electrode (300B),
wherein the first adhesive pattern (WALA1) is disposed between the first opening portion (OP1) and the second opening portion (OP2) in a plan view, optionally wherein the first adhesive pattern (WALA1) at least partially surrounds a perimeter of at least one of the first opening portion (OP1) and the second opening portion (OP2).

14. The display apparatus (1) of any one of claims 8 to 13, wherein the first adhesive pattern (WALA1) comprises a fluoro group.

## Patentansprüche

1. Anzeigevorrichtung (1), die Folgendes umfasst:
ein Substrat (100), das einen Anzeigebereich (DA) umfasst,
eine erste Elektrode (300A), die in dem Anzeigebereich (DA) angeordnet ist,
eine zweite Elektrode (300B), die so in dem Anzeigebereich (DA) angeordnet ist, dass sie zu der ersten Elektrode (300A) benachbart ist,
eine erste Emissionsschicht (313A), die auf der ersten Elektrode (300A) angeordnet ist,
eine zweite Emissionsschicht (313B), die auf der zweiten Elektrode (300B) angeordnet ist,
eine erste Negativladungserzeugungsschicht (319), die durchgehend so angeordnet ist, dass sie die erste Emissionsschicht (313A) und die zweite Emissionsschicht (313B) abdeckt, und einen Host, der ein organisches Material umfasst, und einen Dotierungsstoff, der ein Metallmaterial umfasst, umfasst,
eine erste Positivladungserzeugungsschicht (320), die auf der ersten Negativladungserzeugungsschicht (319) angeordnet ist,
eine erste obere Emissionsschicht (323A), die auf der ersten Positivladungserzeugungsschicht (320) angeordnet ist und die erste Emissionsschicht (313A) überlappt,
eine zweite obere Emissionsschicht (323B), die auf der ersten Positivladungserzeugungsschicht (320) angeordnet ist und die zweite Emissionsschicht (313B) überlappt, und
eine gemeinsame Elektrode (340), die auf der ersten oberen Emissionsschicht (323A) und der zweiten oberen Emissionsschicht (323B) angeordnet ist,
**dadurch gekennzeichnet, dass**
der Dotierungsstoff in einem ersten Verhältnis in einem Überlappungsbereich (319R1, 319R2) der ersten Negativladungserzeugungsschicht (319) bereitgestellt wird, der in einer Draufsicht zwischen einer Mitte (313CA) der ersten Emissionsschicht (313A) und einer Mitte (313CB) der zweiten Emissionsschicht (313B) angeordnet ist, und
der Dotierungsstoff in einem zweiten Verhältnis in einem Außenbereich (319OR) der ersten Negativladungserzeugungsschicht (319) bereitgestellt wird, der außerhalb des Überlappungsbereichs (319R1, 319R2) angeordnet ist,
wobei das erste Verhältnis geringer ist als das zweite Verhältnis.

2. Anzeigevorrichtung (1) nach Anspruch 1, wobei der Host in dem Überlappungsbereich (319R1, 319R2) und dem Außenbereich (319OR) bereitgestellt wird und
der Dotierungsstoff in dem Außenbereich (319OR) bereitgestellt wird.

3. Anzeigevorrichtung (1) nach Anspruch 1 oder Anspruch 2, die ferner ein erstes Klebstoffmuster (WALA1) umfasst, das in dem Überlappungsbereich (319R1, 319R2) angeordnet ist,
wobei die erste Negativladungserzeugungsschicht (319) durchgehend so angeordnet ist, dass sie ferner das erste Klebstoffmuster (WALA1) abdeckt, wahlweise wobei die erste Negativladungserzeugungsschicht (319) und das erste Klebstoffmuster (WALA1) einander direkt berühren.

4. Anzeigevorrichtung (1) nach Anspruch 3, die ferner Folgendes umfasst:
eine dritte Elektrode (300C), die so in dem Anzeigebereich (DA) angeordnet ist, dass sie zu der zweiten Elektrode (300B) benachbart ist,
eine dritte Emissionsschicht (313C), die auf der dritten Elektrode (300C) angeordnet ist,
ein zweites Klebstoffmuster (WALB1), das in einer Draufsicht zwischen der Mitte (313CB) der zweiten Emissionsschicht (313B) und einer Mitte (313CC) der dritten Emissionsschicht (313C) angeordnet ist, und
eine dritte obere Emissionsschicht (323C), welche die dritte Emissionsschicht (313C) überlappt,
wobei die erste Negativladungserzeugungsschicht (319) durchgehend so angeordnet ist, dass sie ferner das zweite Klebstoffmuster (WALB1) und die dritte Emissionsschicht (313C) abdeckt, und
die gemeinsame Elektrode (340) ferner auf der dritten oberen Emissionsschicht (323C) angeordnet ist, wahlweise wobei die erste Emissionsschicht (313A) rotes Licht emittiert,
die zweite Emissionsschicht (313B) grünes Licht emittiert, und
die dritte Emissionsschicht (313C) blaues Licht emittiert.

5. Anzeigevorrichtung (1) nach einem der Ansprüche 1 bis 4, die ferner Folgendes umfasst:
ein erstes zusätzliches Klebstoffmuster (WALA2), das in einer Draufsicht zwischen einer Mitte (313CA) der ersten oberen Emissionsschicht (323A) und einer Mitte (313CB) der zweiten oberen Emissionsschicht (323B) angeordnet ist,
eine zweite Negativladungserzeugungsschicht (329), die durchgehend so angeordnet ist, dass sie die erste obere Emissionsschicht (323A), die zweite obere Emissionsschicht (323B) und das erste zusätzliche Klebstoffmuster (WALA2) abdeckt,
eine zweite Positivladungserzeugungsschicht (330), die auf der zweiten Negativladungserzeugungsschicht (329) angeordnet ist,
eine erste zusätzliche Emissionsschicht (333A), die auf der zweiten Positivladungserzeugungsschicht (330) angeordnet ist und die erste obere Emissionsschicht (323A) überlappt, und
eine zweite zusätzliche Emissionsschicht (333B), die auf der zweiten Positivladungserzeugungsschicht (330) angeordnet ist und die zweite obere Emissionsschicht (323B) überlappt,
wobei die gemeinsame Elektrode (340) ferner auf der ersten zusätzlichen Emissionsschicht (333A) und der zweiten zusätzlichen Emissionsschicht (333B) angeordnet ist.

6. Anzeigevorrichtung (1) nach einem der Ansprüche 1 bis 5, die ferner eine Bildpunkt-Definitionsschicht (PDL) umfasst, die einen ersten Öffnungsabschnitt (OP1), der die erste Elektrode (300A) überlappt, und einen zweiten Öffnungsabschnitt (OP2), der die zweite Elektrode (300B) überlappt, umfasst,
wobei das erste Klebstoffmuster (WALA1) in einer Draufsicht zwischen dem ersten Öffnungsabschnitt (OP1) und dem zweiten Öffnungsabschnitt (OP2) angeordnet ist, wahlweise wobei das erste Klebstoffmuster (WALA1) einen Umfang mindestens eines von dem ersten Öffnungsabschnitt (OP1) und dem zweiten Öffnungsabschnitt (OP2) mindestens teilweise umgibt.

7. Anzeigevorrichtung (1) nach einem der Ansprüche 1 bis 6, wobei das erste Klebstoffmuster (WALA1) eine Fluorgruppe umfasst.

8. Anzeigevorrichtung (1) nach Anspruch 1, die ferner Folgendes umfasst:
ein erstes Klebstoffmuster (WALA1), das in einer Draufsicht zwischen einer Mitte (313CA) der ersten Emissionsschicht (313A) und einer Mitte (313CB) der zweiten Emissionsschicht (313B) angeordnet ist,
wobei die erste Negativladungserzeugungsschicht (319) durchgehend so angeordnet ist, dass sie das erste Klebstoffmuster (WALA1) abdeckt, und
wobei der Dotierungsstoff das erste Klebstoffmuster (WALA1) überlappt.

9. Anzeigevorrichtung (1) nach Anspruch 8, wobei der Host in dem Überlappungsbereich (319R1, 319R2) und dem Außenbereich (319OR) bereitgestellt wird und
der Dotierungsstoff in dem Außenbereich (319OR) bereitgestellt wird.

10. Anzeigevorrichtung (1) nach Anspruch 8 oder Anspruch 9, wobei die erste Negativladungserzeugungsschicht (319) und das erste Klebstoffmuster (WALA1) einander direkt berühren.

11. Anzeigevorrichtung (1) nach einem der Ansprüche 8 bis 10, die ferner Folgendes umfasst:
eine dritte Elektrode (300C), die so in dem Anzeigebereich (DA) angeordnet ist, dass sie zu der zweiten Elektrode (300B) benachbart ist,
eine dritte Emissionsschicht (313C), die auf der dritten Elektrode (300C) angeordnet ist,
ein zweites Klebstoffmuster (WALB1), das in einer Draufsicht zwischen der Mitte (313CB) der zweiten Emissionsschicht (313B) und einer Mitte (313CC) der dritten Emissionsschicht (313C) angeordnet ist, und
eine dritte obere Emissionsschicht (323C), welche die dritte Emissionsschicht (313C) überlappt,
wobei die erste Negativladungserzeugungsschicht (319) durchgehend so angeordnet ist, dass sie ferner das zweite Klebstoffmuster (WALB1) und die dritte Emissionsschicht (313C) abdeckt, und
die gemeinsame Elektrode (340) ferner auf der dritten oberen Emissionsschicht (323C) angeordnet ist, wahlweise wobei die erste Emissionsschicht (313A) rotes Licht emittiert,
die zweite Emissionsschicht (313B) grünes Licht emittiert, und
die dritte Emissionsschicht (313C) blaues Licht emittiert.

12. Anzeigevorrichtung (1) nach einem der Ansprüche 8 bis 11, die ferner Folgendes umfasst:
ein erstes zusätzliches Klebstoffmuster (WALA2), das in einer Draufsicht zwischen einer Mitte (313CA) der ersten oberen Emissionsschicht (323A) und einer Mitte (313CB) der zweiten oberen Emissionsschicht (323B) angeordnet ist,
eine zweite Negativladungserzeugungsschicht (329), die durchgehend so angeordnet ist, dass sie die erste obere Emissionsschicht (323A), die zweite obere Emissionsschicht (323B) und das erste zusätzliche Klebstoffmuster (WALA2) abdeckt,
eine zweite Positivladungserzeugungsschicht (330), die auf der zweiten Negativladungserzeugungsschicht (329) angeordnet ist,
eine erste zusätzliche Emissionsschicht (333A), die auf der zweiten Positivladungserzeugungsschicht (330) angeordnet ist und die erste obere Emissionsschicht (323A) überlappt, und
eine zweite zusätzliche Emissionsschicht (333B), die auf der zweiten Positivladungserzeugungsschicht (330) angeordnet ist und die zweite obere Emissionsschicht (323B) überlappt,
wobei die gemeinsame Elektrode (340) ferner auf der ersten zusätzlichen Emissionsschicht (333A) und der zweiten zusätzlichen Emissionsschicht (333B) angeordnet ist.

13. Anzeigevorrichtung (1) nach einem der Ansprüche 8 bis 12, die ferner eine Bildpunkt-Definitionsschicht (PDL) umfasst, die einen ersten Öffnungsabschnitt (OP1), der die erste Elektrode (300A) überlappt, und einen zweiten Öffnungsabschnitt (OP2), der die zweite Elektrode (300B) überlappt, umfasst,
wobei das erste Klebstoffmuster (WALA1) in einer Draufsicht zwischen dem ersten Öffnungsabschnitt (OP1) und dem zweiten Öffnungsabschnitt (OP2) angeordnet ist, wahlweise wobei das erste Klebstoffmuster (WALA1) einen Umfang mindestens eines von dem ersten Öffnungsabschnitt (OP1) und dem zweiten Öffnungsabschnitt (OP2) mindestens teilweise umgibt.

14. Anzeigevorrichtung (1) nach einem der Ansprüche 8 bis 13, wobei das erste Klebstoffmuster (WALA1) eine Fluorgruppe umfasst.

## Revendications

1. Appareil d'affichage (1) comprenant :
un substrat (100) comprenant une zone d'affichage (DA) ;
une première électrode (300A) disposée dans la zone d'affichage (DA) ;
une deuxième électrode (300B) disposée dans la zone d'affichage (DA) pour être adjacente à la première électrode (300A) ;
une première couche d'émission (313A) disposée sur la première électrode (300A) ;
une deuxième couche d'émission (313B) disposée sur la deuxième électrode (300B) ;
une première couche de génération de charge négative (319) disposée en continu pour recouvrir la première couche d'émission (313A) et la deuxième couche d'émission (313B) et comprenant un hôte comprenant un matériau organique et un dopant comprenant un matériau métallique ;
une première couche de génération de charge positive (320) disposée sur la première couche de génération de charge négative (319) ;
une première couche d'émission supérieure (323A) disposée sur la première couche de génération de charge positive (320) et chevauchant la première couche d'émission (313A) ;
une deuxième couche d'émission supérieure (323B) disposée sur la première couche de génération de charge positive (320) et chevauchant la deuxième couche d'émission (313B) ; et
une électrode commune (340) disposée sur la première couche d'émission supérieure (323A) et la deuxième couche d'émission supérieure (323B),
**caractérisé en ce que**
le dopant est fourni à un premier rapport dans une zone de chevauchement (319R1, 319R2) de la première couche de génération de charge négative (319) disposée entre un centre (313CA) de la première couche d'émission (313A) et un centre (313CB) de la deuxième couche d'émission (313B) dans une vue en plan, et
le dopant est fourni à un deuxième rapport dans une zone extérieure (319OR) de la première couche de génération de charge négative (319) disposée à l'extérieur de la zone de chevauchement (319R1, 319R2),
dans lequel le premier rapport est inférieur au deuxième rapport.

2. Appareil d'affichage (1) selon la revendication 1, dans lequel l'hôte est fourni dans la zone de chevauchement (319R1, 319R2) et la zone extérieure (319OR), et
le dopant est fourni dans la zone extérieure (319OR).

3. Appareil d'affichage (1) selon la revendication 1 ou la revendication 2, comprenant en outre un premier motif adhésif (WALA1) disposé dans la zone de chevauchement (319R1, 319R2),
dans lequel la première couche de génération de charge négative (319) est disposée en continu pour recouvrir en outre le premier motif adhésif (WALA1), facultativement dans lequel la première couche de génération de charge négative (319) et le premier motif adhésif (WALA1) sont directement en contact l'un avec l'autre.

4. Appareil d'affichage (1) selon la revendication 3, comprenant en outre :
une troisième électrode (300C) disposée dans la zone d'affichage (DA) de manière à être adjacente à la deuxième électrode (300B) ;
une troisième couche d'émission (313C) disposée sur la troisième électrode (300C) ;
un deuxième motif adhésif (WALB1) disposé entre le centre (313CB) de la deuxième couche d'émission (313B) et un centre (313CC) de la troisième couche d'émission (313C) dans une vue en plan ; et
une troisième couche d'émission supérieure (323C) chevauchant la troisième couche d'émission (313C),
dans lequel la première couche de génération de charge négative (319) est disposée en continu pour recouvrir en outre le deuxième motif adhésif (WALB1) et la troisième couche d'émission (313C), et
l'électrode commune (340) est en outre disposée sur la troisième couche d'émission supérieure (323C), facultativement dans lequel la première couche d'émission (313A) émet une lumière rouge,
la deuxième couche d'émission (313B) émet une lumière verte, et
la troisième couche d'émission (313C) émet une lumière bleue.

5. Appareil d'affichage (1) selon l'une quelconque des revendications 1 à 4, comprenant en outre :
un premier motif adhésif supplémentaire (WALA2) disposé entre un centre (313CA) de la première couche d'émission supérieure (323A) et un centre (313CB) de la deuxième couche d'émission supérieure (323B) dans une vue en plan ;
une deuxième couche de génération de charge négative (329) disposée en continu pour recouvrir la première couche d'émission supérieure (323A), la deuxième couche d'émission supérieure (323B) et le premier motif adhésif supplémentaire (WALA2) ;
une deuxième couche de génération de charge positive (330) disposée sur la deuxième couche de génération de charge négative (329) ;
une première couche d'émission supplémentaire (333A) disposée sur la deuxième couche de génération de charge positive (330) et chevauchant la première couche d'émission supérieure (323A) ; et
une deuxième couche d'émission supplémentaire (333B) disposée sur la deuxième couche de génération de charge positive (330) et chevauchant la deuxième couche d'émission supérieure (323B),
dans lequel l'électrode commune (340) est en outre disposée sur la première couche d'émission supplémentaire (333A) et la deuxième couche d'émission supplémentaire (333B).

6. Appareil d'affichage (1) selon l'une quelconque des revendications 1 à 5, comprenant en outre une couche de définition de pixels (PDL) comprenant une première partie d'ouverture (OP1) chevauchant la première électrode (300A) et une deuxième partie d'ouverture (OP2) chevauchant la deuxième électrode (300B),
dans lequel le premier motif adhésif (WALA1) est disposé entre la première partie d'ouverture (OP1) et la deuxième partie d'ouverture (OP2) dans une vue en plan, facultativement dans lequel le premier motif adhésif (WALA1) entoure au moins partiellement un périmètre d'au moins une de la première partie d'ouverture (OP1) et de la deuxième partie d'ouverture (OP2).

7. Appareil d'affichage (1) selon l'une quelconque des revendications 1 à 6, dans lequel le premier motif adhésif (WALA1) comprend un groupe fluoré.

8. Appareil d'affichage (1) selon la revendication 1 comprenant en outre :
un premier motif adhésif (WALA1) disposé entre un centre (313CA) de la première couche d'émission (313A) et un centre (313CB) de la deuxième couche d'émission (313B) dans une vue en plan ;
dans lequel la première couche de génération de charge négative (319) est disposée en continu pour recouvrir le premier motif adhésif (WALA1) ; et
dans lequel le dopant chevauche le premier motif adhésif (WALA1).

9. Appareil d'affichage (1) selon la revendication 8, dans lequel l'hôte est fourni dans la zone de chevauchement (319R1, 319R2) et la zone extérieure (319OR), et
le dopant est fourni dans la zone extérieure (319OR).

10. Appareil d'affichage (1) selon la revendication 8 ou la revendication 9, dans lequel la première couche de génération de charge négative (319) et le premier motif adhésif (WALA1) sont directement en contact l'un avec l'autre.

11. Appareil d'affichage (1) selon l'une quelconque des revendications 8 à 10, comprenant en outre :
une troisième électrode (300C) disposée dans la zone d'affichage (DA) de manière à être adjacente à la deuxième électrode (300B) ;
une troisième couche d'émission (313C) disposée sur la troisième électrode (300C) ;
un deuxième motif adhésif (WALB1) disposé entre le centre (313CB) de la deuxième couche d'émission (313B) et un centre (313CC) de la troisième couche d'émission (313C) dans une vue en plan ; et
une troisième couche d'émission supérieure (323C) chevauchant la troisième couche d'émission (313C),
dans lequel la première couche de génération de charge négative (319) est disposée en continu pour recouvrir en outre le deuxième motif adhésif (WALB1) et la troisième couche d'émission (313C), et
l'électrode commune (340) est en outre disposée sur la troisième couche d'émission supérieure (323C), facultativement dans lequel la première couche d'émission (313A) émet une lumière rouge,
la deuxième couche d'émission (313B) émet une lumière verte, et
la troisième couche d'émission (313C) émet une lumière bleue.

12. Appareil d'affichage (1) selon l'une quelconque des revendications 8 à 11, comprenant en outre :
un premier motif adhésif supplémentaire (WALA2) disposé entre un centre (313CA) de la première couche d'émission supérieure (323A) et un centre (313CB) de la deuxième couche d'émission supérieure (323B) dans une vue en plan ;
une deuxième couche de génération de charge négative (329) disposée en continu pour recouvrir la première couche d'émission supérieure (323A), la deuxième couche d'émission supérieure (323B) et le premier motif adhésif supplémentaire (WALA2) ;
une deuxième couche de génération de charge positive (330) disposée sur la deuxième couche de génération de charge négative (329) ;
une première couche d'émission supplémentaire (333A) disposée sur la deuxième couche de génération de charge positive (330) et chevauchant la première couche d'émission supérieure (323A) ; et
une deuxième couche d'émission supplémentaire (333B) disposée sur la deuxième couche de génération de charge positive (330) et chevauchant la deuxième couche d'émission supérieure (323B),
dans lequel l'électrode commune (340) est en outre disposée sur la première couche d'émission supplémentaire (333A) et la deuxième couche d'émission supplémentaire (333B).

13. Appareil d'affichage (1) selon l'une quelconque des revendications 8 à 12, comprenant en outre une couche de définition de pixels (PDL) comprenant une première partie d'ouverture (OP1) chevauchant la première électrode (300A) et une deuxième partie d'ouverture (OP2) chevauchant la deuxième électrode (300B),
dans lequel le premier motif adhésif (WALA1) est disposé entre la première partie d'ouverture (OP1) et la deuxième partie d'ouverture (OP2) dans une vue en plan, facultativement dans lequel le premier motif adhésif (WALA1) entoure au moins partiellement un périmètre d'au moins une de la première partie d'ouverture (OP1) et de la deuxième partie d'ouverture (OP2).

14. Appareil d'affichage (1) selon l'une quelconque des revendications 8 à 13, dans lequel le premier motif adhésif (WALA1) comprend un groupe fluoré.
